# EUROPÄISCHE PATENTSCHRIFT

(11) **EP 2 174 329 B1**
(45) Veröffentlichungstag und Bekanntmachung des Hinweises auf die Patenterteilung: **09.02.2011**
(21) Anmeldenummer: 08786301.5
(22) Anmeldetag: 22.07.2008
(51) Int. Cl.: H01L 27/30, H01G 9/20, H01L 51/42

(54) **PHOTOVOLTAISCHE TANDEM-ZELLE**
PHOTOVOLTAIC TANDEM CELL
PILES TANDEM PHOTOVOLTAIQUES

(30) Priorität: 23.07.2007 EP 07112948
(43) Veröffentlichungstag der Anmeldung: 14.04.2010
(73) Patentinhaber: BASF SE, 67056 Ludwigshafen (DE)
(72) Erfinder: PSCHIRER, Neil Gregory, 55116 Mainz (DE); EICKEMEYER, Felix, 68159 Mannheim (DE); SCHÖNEBOOM, Jan, 68199 Mannheim (DE); HWANG, Jae Hyung, 68199 Mannheim (DE); KARLSSON, Martin, 68169 Mannheim (DE); BRUDER, Ingmar, 67059 Ludwigshafen (DE)
(86) Internationale Anmeldenummer: PCT/EP2008/059565
(87) Internationale Veröffentlichungsnummer: WO 2009/013282

(56) Entgegenhaltungen:
- EP-A- 1 724 838
- WO-A-2004/112161
- US-A1- 2007 062 576

## Beschreibung

Die Erfindung betrifft ein photovoltaisches Element mit einem Tandemzellenaufbau gemäß dem Oberbegriff des Anspruchs 1. Derartige photovoltaische Elemente werden eingesetzt, um elektromagnetische Strahlung, insbesondere Sonnenlicht, in elektrische Energie umzuwandeln.

Die Direktumwandlung von Solarenergie in elektrische Energie in Solarzellen beruht in der Regel auf dem so genannten "inneren Photoeffekt" eines Halbleitermaterials, d.h. der Erzeugung von Elektron-Loch-Paaren durch Absorption von Photonen und der Trennung der negativen und positiven Ladungsträger an einem p-n-Übergang oder einem Schottky-Kontakt. Auf diese Weise wird eine Photospannung erzeugt, welche in einem äußeren Stromkreis einen Photostrom bewirken kann, durch den die Solarzelle ihre Leistung abgibt.

Von dem Halbleiter können dabei in der Regel nur solche Photonen absorbiert werden, die eine Energie aufweisen, die größer als seine Bandlücke ist. Die Größe der Halbleiterbandlücke bestimmt also den Anteil des Sonnenlichts, der in elektrische Energie umgewandelt werden kann.

Solarzellen, welche auf kristallinem Silizium basieren, wurden schon in den 1950er Jahren produziert. Die Technologie wurde damals durch die Anwendung bei Weltraumsatelliten gefördert. Obwohl auf Silizium basierende Solarzellen den Markt auf der Erde jetzt dominieren, bleibt diese Technologie nach wie vor kostenintensiv. Daher wird versucht, neue Ansätze zu entwickeln, die kostengünstiger sind. Im Folgenden werden einige dieser Ansätze skizziert, welche die Grundlage der vorliegenden Erfindung darstellen.

### Farbstoffsolarzellen

Die Farbstoffsolarzelle (auch Dye Solar Cell, DSC) ist bisher eine der effizientesten alternativen Solarzellen-Technologien. Bei einer flüssigen Variante dieser Technologie werden derzeit Wirkungsgrade von bis zu 11% erzielt (siehe z.B. Grätzel M. et al., J. Photochem. Photobio. C, 2003, 4, 145; Chiba et al., Japanese Journal of Appl. Phys., 2006, 45, L638-L640).

Als Einzelelemente aufgebaute Farbstoffsolarzellen, von denen es mittlerweile mehrere Varianten gibt, weisen in der Regel zwei Elektroden auf, von denen mindestens eine transparent ist. Die beiden Elektroden werden gemäß ihrer Funktion als "Arbeitselektrode" (auch "Anode", Generierung von Elektronen) und "Gegenelektrode" (auch "Kathode") bezeichnet. Auf der Arbeitselektrode oder in der Nähe derselben ist in der Regel ein n-leitendes Metalloxid aufgebracht, beispielsweise eine ca. 10-20 µm dicke, nanoporöse Schicht Titandioxid (TiO₂). Auf dessen Oberfläche wiederum ist üblicherweise eine Monolage eines Licht-sensitiven Farbstoffes (beispielsweise ein Ruthenium-Komplex) adsorbiert, welcher sich durch Lichtabsorption in einen angeregten Zustand überführen lässt. Auf oder an der Gegenelektrode befindet sich häufig eine wenige µm dicke katalytische Schicht, beispielsweise Platin. Der Bereich zwischen den beiden Elektroden ist mit einem Redoxelektrolyten, z.B. einer Lösung aus lod (I₂) und Kaliumiodid (KI), gefüllt.

Die Funktion der Farbstoffsolarzelle beruht darauf, dass Licht vom Farbstoff absorbiert wird. Von dem angeregten Farbstoff werden Elektronen auf den n-halbleitenden Metalloxid-Halbleiter übertragen und wandern auf diesem zur Anode, wohingegen der Elektrolyt für einen Ladungsausgleich über die Kathode sorgt. Das n-halbleitende Metalloxid, der Farbstoff und der Elektrolyt sind also die wesentlichen Bestandteile der Farbstoffsolarzelle.

Die mit flüssigem Elektrolyten erstellte Farbstoffsolarzelle leidet jedoch in vielen Fällen unter einer nicht optimalen Versiegelung, was zu Stabilitätsproblemen führen kann. Der flüssige Elektrolyt kann allerdings durch einen festen p-Halbleiter ersetzt werden. Der Wirkungsgrad der festen Variante der Farbstoffsolarzelle beträgt momentan ca. 4,6-4,7% (Snaith, H., Angew. Chem. Int. Ed., 2005, 44, 6413-6417).

Verschiedene anorganische p-Halbleiter wie Cul, CuBr . 3(S(C₄H₉)₂) oder CuSCN wurden bisher in Feststoff-Farbstoffsolarzellen verwendet. Auch in der Natur ist es das Cu(I) Enzym Plastocyanin, das im Photosystem I das oxidierte Chlorophyll-Dimer wieder reduziert. Solche p-Halbleiter lassen sich über mindestens drei verschiedene Methoden verarbeiten, nämlich: aus einer Lösung, durch Elektrodeposition oder durch Laser Deposition.

Dabei können sich jedoch in der Praxis teilweise Probleme mit der Stabilität der p-Halbleiter ergeben, welche insbesondere durch zu große Halbleiterkristalle und schlechten Kontakt zum Farbstoff entstehen. Ein Ansatz, dies zu verhindern, besteht in einer Cul-Lösung in einem organischen Lösungsmittel mit dem Zusatz einer ionischen Flüssigkeit als Kristallisationsinhibitor. Hierbei lassen sich verschiedene Kristallisationsinhibitoren einsetzen (meistens SCN-Salze), und es wurden Effizienzen bis zu 3,75% erzielt. Eine andere Gruppe verwendete eine mit ZnO bedeckte, nanoporöse TiO₂-Schicht in Verbindung mit Cul und 1-Methyl-3-Ethylimidazolium-Thiocyanat (MEISCN). Diese Farbstoffsolarzellen zeigten eine Effizienz von 3,8%. Wird TiO₂ mit MgO bedeckt und Cul (als p-Leiter) mit Triethylamin-Hydrothiocyanat (als Kristallisationsinhibitor) verwendet, so werden Effizienzen von bis zu 4,7% erzielt. CuSCN kann auch aus einer Lösung als fester p-Halbleiter eingesetzt werden und zeigt einen Wirkungsgrad von etwa 2%. Elektrochemische Abscheidung sollte ein besseres Eindringen in die mesoporösen Poren ermöglichen, wenn der p-Halbleiter bei negativen Potentialen abgeschieden werden kann. Bei dieser Methode liefern feste Farbstoffsolarzellen Wirkungsgrade von 1,5%, obwohl in der Regel aufgrund einer relativ dünnen ZnO-Schicht nur ca. 12% des eingestrahlten Lichtes absorbiert wird. Letztlich werden durch Laserabscheidung relativ kleine Körner hergestellt, was zu einem sehr guten Kurzschlussstrom I_{SC} von ca. 12,2 mA/cm² führt, trotz einer etwa 10 Mikrometer dicken TiO₂-Schicht, und einer Effizienz von ca. 2,8% bei einer aktiven Fläche von ca. 1 cm².

Auch organische Polymere wurden bereits als feste p-Halbleiter verwendet. Beispiele davon schließen Polypyrrol, Poly(3,4-ethylendioxythiophen), Carbazol-basierte Polymere, Polyanilin, Poly(4-undecyl-2,2'-bithiophen), Poly(3-octylthiophen), Poly(triphenyldiamin) und Poly(N-vinylcarbazol) ein. Die Effizienzen erreichen im Fall des Poly(N-vinylcarbazol) bis zu 2%. Auch ein in-situ polymerisiertes PEDOT (Poly(3,4-ethylendioxythiophen) hat eine Effizienz von 0,53% gezeigt. Die hier beschriebenen Polymere werden typischerweise nicht rein eingesetzt, sondern mit Additiven.

Auch niedermolekulare organische p-Halbleiter lassen sich einsetzen. Der erste Einsatz eines niedermolekularen p-Halbleiters in Feststoff-Farbstoffsolarzellen ersetzte den flüssigen Elektrolyten durch eine aufgedampfte Schicht Triphenylamins (TPD). Vom Einsatz der organischen Verbindung 2,2'7,7'-tetrakis(N,N-di-p-Methoxyphenyl-amin)-9,9'-spirobifluoren (Spiro-MeOTAD) in Farbstoffsolarzellen wurde 1998 berichtet. Sie lässt sich aus einer Lösung einbringen und besitzt eine relativ hohe Glastemperatur, was eine ungewünschte Kristallisierung und einen schlechten Kontakt zum Farbstoff verhindert. Die Methoxygruppen stellen das Oxidationspotential des Spiro-MeOTADs so ein, dass der Ru-Komplex effizient regeneriert werden kann. Beim Einsetzen des Spiro-MeOTADs allein als p-Leiter ergab sich eine maximale IPCE (incident photon to current conversion efficiency, externe Photonen-Konversionseffizienz) von 5%. Wenn N(PhBr)₃SbCl₆ (als Dotierstoff) und Li[(CF₃SO₂)₂N] mit eingesetzt wurden, stieg die IPCE auf 33%, und die Effizienz betrug 0,74%. Durch den Einsatz von tert-Butylpyridin als festen p-Halbleiter ließ sich die Effizienz auf 2,56% steigern, wobei die Spannung bei unterbrochenem Stromkreis (V_{oc}) ca. 910 mV betrug und der Kurzschlussstrom I_{SC} ca. 5 mA bei einer aktiven Fläche von ca. 1.07 cm² (siehe Krüger et al., Appl. Phys. Lett., 2001, 79, 2085). Farbstoffe, die eine bessere Bedeckung der TiO₂ Schicht erzielten und die eine gute Benetzung auf Spiro-MeOTAD aufweisen, zeigen Effizienzen von über 4%. Von noch besseren Effizienzen (ca. 4,6%) wurde berichtet, wenn der Ruthenium-Komplex mit Oxyethylenseitenketten ausgestattet war.

In Adv. Mater. 17, S. 813-815 (2005) wird für Farbstoffsolarzellen mit Spirobifluorenen als amorphem organischem p-Leiter ein Indolinfarbstoff vorgeschlagen. Dieser organische Farbstoff, welcher einen vierfach höheren Extinktionskoeffizienten als ein Ruthenium-Komplex aufweist, zeigt eine hohe Effizienz (4,1% bei einer Sonne) in Feststoff-Farbstoffsolarzellen.

Außerdem wurde ein Konzept vorgestellt, in dem polymere p-Halbleiter direkt an einen Ru-Farbstoff gebunden sind (Peter, K., Appl. Phys. A 2004, 79, 65).

In Durrant et al., Adv. Munc. Mater. 2006, 16, 1832-1838, wird beschrieben, dass in vielen Fällen der Photostrom direkt von der Ausbeute beim Lochübergang vom oxidierten Farbstoff zum festen p-Leiter abhängig ist. Dies hängt von zwei Faktoren ab: erstens vom Ausmaß des Eindringens des p-Halbeiters in die Oxidporen und zweitens von der thermodynamischen Triebkraft für den Ladungstransfer (also insbesondere dem Unterschied in der Freien Enthalpie ΔG zwischen Farbstoff und p-Leiter).

Ein Nachteil der Farbstoffsolarzelle liegt darin, dass der Anteil an Licht, das vom Farbstoff verwendet werden kann, durch den energetischen Abstand zwischen den Fermi-Energien der verwendeten n- und p-Leiter eingeschränkt wird. Auch die Photospannung ist durch diesen Abstand beschränkt. Zudem müssen Farbstoffsolarzellen in der Regel aufgrund des erforderlichen Ladungstransportes vergleichsweise dünn ausgestaltet werden (beispielsweise 1-2,5 Mikrometer), so dass die Ausnutzung des einfallenden Lichtes in der Regel nicht optimal ist.

### Organische Solarzellen

Photovoltaische Elemente, welche auf einem p-n-Übergang basieren, bei denen einige oder sogar alle der photoaktiven Materialien organisch sind, sind seit fast 50 Jahren bekannt (siehe z.B. Kearns, K, Calvin, M., J., Chem. Phys. 1958, 29, 950-951). Derartige Elemente sind so konzipiert, dass mindestens einer der Halbleiter (n-Halbleiter und/oder p-Halbleiter) ein Photon absorbiert, wobei das dabei entstehende Exziton zum p-n-Übergang transportiert wird und von dort eine oder beide der zwei Ladungen zur Elektrode transportiert wird bzw. werden.

Organische Solarzellen können aus niedermolekularen Verbindungen (im Folgenden auch "Niedermolekularzellen" genannt), aus Polymeren (im Folgenden auch "Polymerzellen" genannt), aus Oligomeren oder aus Kombinationen einiger oder mehrerer dieser Materialien zusammengesetzt sein. Organische Solarzellen weisen mindestens ein Akzeptormaterial auf, in welchem der n-Ladungstransport (Elektronentransport) dominiert und welches somit das organische Analogon zu einem n-Halbleiter darstellt sowie mindestens ein Donatormaterial, in welchem der p-Ladungstransport (Lochtransport) dominiert und welches somit das organische Analogon zu einem p-Halbleiter darstellt. Alternativ oder zusätzlich können auch anorganische Nanopartikel als Akzeptor eingesetzt werden (siehe z.B. Alivisatos A., Science, 2002, 295, 2425-2427).

Die Vielfalt an organischen photovoltaischen Konzepten kann zum Zweck dieser Beschreibung nach Verarbeitungsmethoden geordnet werden. Die Materialien werden typischerweise im Vakuum aufgebracht (z.B. mittels physical vapor deposition, PVD, chemical vapor deposition, CVD, Molekularstrahlepitaxie oder anderen Verfahren oder Verfahrenskombinationen) und/oder aus einer Lösung (z.B. durch Spin-Coating, Drucken oder andere nasschemische Technologien) abgeschieden. Auch Hybride dieser Zelltypen und Abscheidungsmethoden existieren, beispielsweise Zellen mit niedermolekularen, im Vakuum aufgebrachten Schichten und polymeren, nasschemisch aufgebrachten Schichten.

Niedermolekularzellen, bei denen beide p- und n-Materialien im Vakuum abgeschieden werden, sind seit mehreren Jahren bekannt (siehe z.B. Tang, C.W., App.Phys. Lett. 1986, 48, 183). Diese Zellen bestehen bisher meistens aus Kupferphthalocyanin (CuPc) als Donatormaterial und aus 3,4,9,10-Perylentetracarbonsäurebisimidbenzimidazol (PTCBI) oder aus einem Fulleren (z.B. C60) als Akzeptormaterial. Die erste Zelle von Tang zeigte einen Wirkungsgrad von etwa 1%. Zellen, die aus den gleichen organischen Materialien hergestellt wurden, wurden mittlerweile verbessert und erreichen einen Wirkungsgrad von 2,7% (Peumans et al., Nature of Materials, 2005, 4, 37-41).

Die Effizienzen von Zellen, bei denen C60 als Akzeptormaterial eingesetzt wird, sind mittlerweile auf 5,0% gestiegen. Hierfür sind zwei Ansätze verantwortlich:
In einem ersten Ansatz erhöht statt einem glatten Schichtaufbau eine so genannte "Bulk Heterojunktion" die Grenzfläche zwischen n- und p-Material. Damit wird ein erhöhter Anteil an Exzitonen in ein freies Loch und ein Elektron getrennt und kann zu einem Strom führen.

In einem zweiten Ansatz wird ein eine Exzitonen-Blockierschicht (Exciton Blocking Layer, EBL) zwischen Akzeptorschicht und Kathode eingesetzt. Diese Schicht soll dazu führen, dass die Exzitonen nicht zur Kathode wandern, wo diese am Übergang zwischen Metall und organischen Schichten ungenutzt zerfallen würden. Weiterhin dienen diese Blockierschichten auch als Difussionsbarrierre gegen das Eindringen der Elektrode in das photoaktive Material.

Wenn CuPc in der Tang-Zelle durch SubPc (Subphthalocyanin) ersetzt wird, lassen sich auch höhere Photospannungen V_{oc} erzielen (bis zu ca. 0.97 V, vgl. Mutolo, K., J. Am. Chem. Soc., 2006, 128, 8108). Andere Materialkombinationen, wie Oligiothiophene (z.B. α, α'-bis(2,2-Dicyanovinyl)-Quinquethiophene, DCV5T) als Donatormaterial mit C₆₀ als Akzeptormaterial zeigen auch hohe Effizienzen (z.B. 3,4-3,8%, vgl. Schulze et al., Adv. Mater., 2006, 18, 2872-2875; Schulze et al., Proc. Of SPIE Vol. 6192, 61920C-1 (2006)). Eine neuere Arbeit setzt so genannte "Triplett"-Absorber ein, die eine hohe Exzitonendiffusionslänge aufweisen (Yang, Y. Adv. Mater., 2005, 17, 2841).

Ein alternativer Ansatz zur Verwendung von Vakuumverfahren für das Aufbringen von niedermolekularen Substanzen ist die Verwendung von löslichen niedermolekularen Verbindungen, die sich, analog zu Polymeren oder Oligomeren, ebenfalls nasschemisch aufbringen lassen. Derart hergestellte Zellen funktionieren auf dem gleichen Prinzip wie die oben beschriebenen Niedermolekularzellen. Hierbei werden p- und n-Materialien aus einer oder mehreren Lösungen und/oder Dispersionen verarbeitet. Eine Vielzahl derartiger Moleküle wurde bereits in solchen Zellen eingesetzt, aber die Effizienzen waren bislang vergleichsweise niedrig. Eine Verbesserung der Effizienz lässt sich durch eine Temperaturbehandlung (Tempern) des Übergangs (d.h. der Bulk-Heterojunction) erzielen, da dies die Anordnung der Moleküle verbessert. Dieser Effekt macht sich besonders bemerkbar, wenn die eingesetzten Moleküle thermotropische Flüssigkristalle sind (vgl. Schmidt-Mende, L. et al., Science 2001, 293, 1119-1122).

Ein weiteres Konzept besteht darin, das Donatormaterial und das Akzeptormaterial kovalent in einem Molekül zu binden. Ein derartig aufgebauter Zelltyp hat jedoch bisher lediglich vergleichsweise geringe Effizienzen gezeigt (vgl. Maggini, M., Chem. Commun., 2002, 2028-2029).

Polymerzellen funktionieren auf dem gleichen Prinzip wie die oben beschriebenen Niedermolekularzellen. Der Unterschied liegt darin, dass mindestens einer der zwei Absorber (d.h. Akzeptormaterial und/oder Donatormaterial) ein Polymer ist und daher in der Regel aus der Lösung verarbeitet wird. Beispiele verwendbarer Polymere sind die Derivate des Poly(p-Phenylen-Vinylen) (PPV), unter denen sich, je nach Substituenten, sowohl Donatormaterialien als auch Akzeptormaterialien finden. Ein typisches Beispiel eines als Donatormaterial wirkenden Polymers ist MEH-PPV (Methylhexylsubstituiertes PPV), wohingegen cyano-substituiertes PPV (CN-PPV) als ein Akzeptormaterial wirken kann. Effizienzen derartig aufgebauter Polymerzellen lagen im Bereich von 1%. Die Systeme, die bisher die besten Leistungen gezeigt haben, bestehen aus P3HT (Poly(3-hexylthiophen)) als Donatormaterial und PCBM ([6,6]-Phenyl-C₆₁-buttersäuremethylester) als Akzeptormaterial. Solarzellen mit Effizienzen bis zu zwischen 4,8 und 5,0% sind bekannt. Auch Polymere mit kleiner Bandlücke (Low Band Gap Polymers) werden eingesetzt und zeigen einen verbesserten Überlapp der Absorption mit dem Sonnenspektrum. Unter Verwendung von PCBM lassen sich Effizienzen von ca. 3.2% erzielen. Hierbei wurden teilweise auch optische Abstandhalter (Optical Spacers) eingesetzt, um die Lichtabsorption in der aktiven Schicht zu maximieren. In App. Phys. Lett, 2001, 78, 841 wurde gezeigt, dass der Einfluss auf den Wirkungsgrad von der Verarbeitung (z.B. dem verwendeten Lösungsmittel usw.) abhängt. Um den Anteil an absorbierten Photonen zu verbessern, werden neue Materialen eingesetzt, wie z.B Polymere mit einer kleinen Bandlücke, wie z.B. PCPDTBT (Poly [2,6-(4,4-bis-(2ethylhexyl)-4*H*-cyclopenta[2,1-b;3,4-b']-dithiophen)-*alt*-4,7-(2,1,3-benzothiadiazol)] zusammen mit C71-PCBM, welche eine Effizienz von bis zu 5,5% zeigen. Polymere werden auch als Donatormaterialien mit u.a. Perylenen oder mit anorganischen Nanostäbchen als Akzeptormaterialien eingesetzt, mit einem Wirkungsgrad bis zu 1,7% im letzteren Fall.

Organische Solarzellen, die aus einer Lösung verarbeitet werden, haben den Vorteil, dass sie eine Vielzahl kostengünstiger Herstellungsverfahren ermöglichen, die für einen hohen Durchsatz geeignet sind. So lassen sich beispielsweise Druckverfahren zur Herstellung einsetzen, wie beispielsweise Tintenstrahldruckverfahren, welche auch eine Strukturierung der organischen Schichten ermöglichen.

### Tandemsolarzellen

Um die Energie der Photonen besser zu nutzen, bieten sich so genannte "Tandem"-Konzepte an (vgl. z.B. Meissner, D., Solarzellen, S. 129-136, Friedr. Vieweg & Sohn Verlagsgesellschaft mbH, 1993). Tandemzellen aus anorganischen Halbleitern sind bekannt und weisen hohe Wirkungsgrade bei irdischen Lichtintensitäten auf. Bekannte Beispiele derartiger Tandemsolarzellen sind: GalnP/GaAs/Ge (32% ± 1,5), GalnP/GaAs (30,3%), GaAs/CIS (25,8% ± 1,3) und a-Si/µc-Si (11,7% ± 0,4) (Green, M.A., Prog. Photovolt; Res. Appl. 2006, 14, 455-461).

Tandem-Solarzellen sind unter anderem deshalb in vielen Fällen vorteilhaft, da die Herstellungskosten der Zellen in der Regel flächenabhängig sind. Die Effizienz der Solarzellen sollte somit so hoch wie möglich sein, was durch die Tandemzellen realisierbar ist.

Es gibt Zwei- und Vier-Kontakt-Tandemsolarzellen. Bei Vier-Kontakt-Tandemsolarzellen werden beide Teilzellen über einen optischen Koppler (z.B. Glas oder eine transparente Folie) miteinander verbunden, wobei jede Solarzelle ihre eigenen elektrischen Anschlüsse behält. Der Vorteil hierbei liegt darin, dass beide Teilzellen getrennt optimiert werden können. Ein Nachteil bei dieser Art von Tandemzelle ist jedoch, dass zusätzliche Reflexionen und Absorptionen durch die zusätzlichen elektrischen Anschlüsse und den optischen Koppler auftreten können.

Bei Zwei-Kontakt-Tandemsolarzellen erfolgt die elektrische Kontaktierung zur Stromabnahme am oberen Frontkontakt der oberen Teilzelle und am unteren Kontakt der unteren Teilzelle, d.h. beide Teilzellen sind direkt elektrisch gekoppelt. Hier werden weniger Schichten benötigt, so dass geringere Reflexions- und Absorptionsverluste auftreten. Weiterhin ist dieses Konzept aufgrund der geringeren Anzahl an Schichten kostengünstiger. Allerdings müssen bei der Zwei-Kontakt-Tandemsolarzelle die Ströme beider Teilzellen angepasst werden. Erst dann lässt sich im Betrieb (d.h. bei geschlossenem Stromkreis) die Summe der individuellen Spannungen der beiden Teilzellen gewinnen. EP1724838A1 beschreikt eine tandemzelle in welcher eine farbstoffsolorzelle mit einer anorganischen Düunschichtsolarzelle gekoppelt wird.

Mittlerweile sind auch erste Tandemsolarzellen bekannt, welche auf Polymermaterialien basieren, insbesondere Polymertandemzellen mit zwei Kontakten (Hadipour, A., Adv. Func. Mater., 2006, 16, 1897). Diese Bauelemente zeigen eine Leerlaufphotospannung (V_{OC}) von ca. 1,4 V. Die für diese Bauelemente offenbarten Messwerte lassen erkennen, dass die obere Solarzelle einen geringeren Strom als die untere Solarzelle liefert. Der gesamte Strom der Tandemzelle ist durch diese Diskrepanz limitiert. Da die Leerlaufphotospannung der Tandemzelle die Summe aus beiden Zellen ist, ist der Wirkungsgrad besser als der jeder einzelnen Zelle. Die Zelle wurde wie folgt aufgebaut: Glassubstrat / Cr (1nm) / Au (15nm) / PEDOT:PSS (60nm) / PFDTBT (Poly((2,7-(9,9-dioctyl)-fluoren)-alt-5,5-(4',7'-di-2-thienyl-2',1',3'-benzothiadiazol) und PCBM (1:4) / LiF (0,5nm) / Al (0,5nm) / Au (15nm) / PEDOT:PSS (60nm) PTBEHT (Poly{5,7-di-2-thienyl-2,3-bis(3,5-di(2-ethylhexyloxy)phenyl)-thieno[3,4-b]pyrazin}) und PCBM (1:4) / LiF (1nm)/ / Al (100nm).

Auch bei Niedermolekularzellen kann ein Tandem-Aufbau von Vorteil sein. Durch Verwendung einer Zwei-Kontakt-Tandemzelle aus zwei Niedermolekularzellen lässt sich die Effizienz von ca. 5.0% auf ca. 5,7% steigern (Forrest et al., Applied Physics Letters, 2004, 85, 5757-5759 und WO 02/101838). Bemerkenswert ist hierbei, dass bei diesem Aufbau die Photospannung größer 1 V ist. Die Zelle wurde folgendermaßen aufgebaut: Glassubstrat / Indium Tin Oxide (ITO) / CuPc / CuPC:C₆₀ / C₆₀ / PTCBI / Ag / m-MTDATA (4,4',4"-tris((3-Methylphenyl)-(phenyl)amino)triphenylamin) (p-dotiert mit 5 mol% Tetrafluor-tetracyanchinodimethan / CuPc / CuPC:C₆₀ / C₆₀ / BCP (Bathocuproin) /Ag(100nm).

Ähnliche Zellen wurden auch mit CuPc und PTCBI hergestellt (Triyana K., Jap. J. Appl. Phys., 2004, 43, 2352-2356). Hier wurde Ag mit Au als Mittelelektrode (als "floating"-Elektrode, d.h. unkontaktierte Elektrode) sowie als Topelektrode verglichen. Die beste Effizienz wurde mit einer aus drei Teilzellen hergestellten Tandemzelle erzielt und betrug ca. 2,37% bei einer V_{oc} zwischen 1,35 V und 1,50 V. Der Zellaufbau war wie folgt: Glas / ITO / PEDOT:PSS / Organisch / Ag / Organisch / Ag / Organisch / Ag, wobei der Ausdruck "organisch" hier für CuPc / PTCBI steht.

Weiterhin sind auch Tandemzellen mit Methyl-Perylentetracarbonsäuredümid (Me-PTC) und Metall-freiem Phthalocyanin (H₂P_{c}) bekannt (Hiramoto, M., Chem. Lett. 1990, 327, 1990). Bei diesen Zellen war jedoch die Effizienz noch vergleichsweise gering. Auch Tandem-Solarzellen, bei denen organische Teilzellen auf Polymer-Teilzellen aufgedampft werden, sind bekannt.

Auch Vier-Kontakt-Farbstofftandemsolarzellen wurden hergestellt und zeigten eine Effizienz von 10,5% (siehe Dürr, M. et al., App. Phys. Lett., 2004, 84, 3397). Dabei wurde ein Polymer-Gel-Elektrolyt mit I⁻/I₃⁻ verwendet, in Kombination mit Cis-bis(Isothiocyanato)bis(2,2'-bipyridyl-4,4'-dicarbonsäure) Ruthenium(II) als rotem Farbstoff in der vorderen Teilzelle und tri(Isothiocyanato)(2,2':6',2"-terpyridyl-4,4',4"-tricarbonsäure)R (II) als schwarzer Farbstoff in der hinteren Teilzelle. Da die Teilzellen nicht elektrisch gekoppelt sind, wurden die Kurzschlussphotoströme addiert.

Eine n-p-Tandemfarbstoffsolarzelle wurde zuerst von Hagfeldt et al. 2000 beschrieben (He, J., Hagfeldt, A., et al., Solar Energy Materials & Solar Cells, 2000, 62, 265). Hierbei wurde zwischen sensibilisierten Photoanoden (TiO₂, cis-bis(Isothiocyanato)bis(2,2'-bipyridyl-4,4'-dicarbonsäure) Ruthenium(II)) und sensibilisierten Photokathoden (NiO, Erythrosin B) ein Elektrolyt aus Lil (0,5 M), I₂ (0,05 M) in Ethylencarbonat / Propylencarbonat eingefüllt. Obwohl eine höhere Photospannung (732 mV) beobachtet wurde, blieb die Effizienz jedoch eher gering (0,39%).

Eine ähnliche Arbeit setzte als Photokathode NiO / 3-Carboxymethyl-5-[2-(3-octadecyl-2-benzothiazolinyliden)ethyliden]-2-thioxo-4-thiazolidin ein (Nakasa, A., Chem Lett., 2005, 34, 500; JP 2006147280). Hierbei stieg die Effizienz auf 0,78% und die maximal beobachtete Photospannung auf 0,918 V. Auch diese Zellen weisen somit noch vergleichsweise niedrige Effizienzen und Photospannungen auf.

Insgesamt sind diese Tandemzellenkonzepte, die auf einer doppelt sensibilisierten Farbstoffzelle mit sensibilisierter Photoanode und sensibilisierter Photokathode beruhen, jedoch vom Aufbau her komplex und lassen hinsichtlich der erzielten Effizienzen erheblichen Raum für Verbesserungen. Auch die Verwendung der flüssigen Elektrolyten macht sich stark negativ bemerkbar. Zudem sind die bislang erreichten Spannungen (open circuit voltage, V_{OC}) noch vergleichsweise gering (typischerweise kleiner als 1 V), und sind bislang noch keine ausreichend effizient sensibilisierten Photokathoden bekannt.

Aufgabe der vorliegenden Erfindung ist es daher, ein photovoltaisches Element bereitzustellen, welches die Nachteile der oben beschriebenen, aus dem Stand der Technik bekannten Elemente vermeidet. Das photovoltaische Element soll insbesondere eine hohe Quanteneffizienz aufweisen und einfach herzustellen sein.

Diese Aufgabe wird gelöst durch ein photovoltaisches Element mit den Merkmalen des unabhängigen Anspruchs 1. Vorteilhafte Weiterbildungen, welche einzeln oder in Kombination realisiert werden können, sind in den Unteransprüchen dargestellt. Der Wortlaut sämtlicher Ansprüche wird hiermit zum Inhalt dieser Beschreibung gemacht.

Es wird ein photovoltaisches Element zur Umwandlung elektromagnetischer Strahlung in elektrische Energie vorgeschlagen, welches einen Tandemzellenaufbau aufweist. Der Tandemzellenaufbau umfasst folgendes:
- eine Farbstoffsolarzelle mit einer ersten Elektrode, einem n-halbleitenden Metalloxid, einem in einem ersten Spektralbereich elektromagnetische Strahlung absorbierenden Farbstoff und einem festen p-Halbleiter; und
- eine organische Solarzelle mit einem Akzeptormaterial und einem Donatormaterial, wobei das Akzeptormaterial und/oder das Donatormaterial ein organisches Material umfasst, wobei die organische Solarzelle weiterhin auf einer der Farbstoffsolarzelle gegenüberliegenden Seite eine zweite Elektrode umfasst, wobei die organische Solarzelle ausgestaltet ist, um elektromagnetische Strahlung in einem zweiten Spektralbereich zu absorbieren, welcher von dem ersten Spektralbereich zumindest teilweise verschieden ist,
- wobei die erste Elektrode und/oder die zweite Elektrode für die elektromagnetische Strahlung zumindest teilweise transparent ist.

Unter einer "transparenten" Elektrode ist in diesem Zusammenhang insbesondere zu verstehen, dass innerhalb des sichtbaren Spektralbereiches und/oder im Bereich des Sonnenspektrums (ca. 300 nm bis 2000 nm) eine Transmission von mindestens 50% besteht, vorzugsweise von mindestens 80%.

Die vorliegende Erfindung betrifft also die Kombination der zwei Hauptarten organischer Solarzellen, nämlich Farbstoffsolarzellen mit Farbstoff-sensiblisierten Metalloxiden und die organischen Solarzellen, welche organische Monomere, Oligomere oder Polymere aufweisen (sowie ggf. anorganische Nanopartikel oder andere Zusätze), wobei mindestens das Akzeptormaterial (n-Halbleiter) oder das Donatormaterial (p-Halbleiter) ein organisches Material aufweist. Neben diesem Grundaufbau können auch weitere Zellen vorliegen, beispielsweise ein Aufbau, bei welchem, zusätzlich zu der genannten Kombination aus Farbstoffsolarzelle und organischer Solarzelle noch mindestens eine weitere Zelle vorhanden ist, also beispielsweise ein dreizelliger Aufbau ("Triple-Cell-Aufbau"). Allgemein ist jedoch im Rahmen der vorliegenden Erfindung ein übereinander geschichteter, zweizelliger Aufbau bevorzugt wird, also ein Aufbau, bei welchem die oben beschriebenen Komponenten (Farbstoffsolarzelle und organische Solarzelle) schichtweise übereinander gelagert bzw. angeordnet sind. Vorzugsweise sind alle eingesetzten Materialien feste Materialien. Weiterhin wird vorzugsweise die Farbstoffsolarzelle als vordere, also der Bestrahlungsseite zugewandte Teilzelle eingesetzt, und die organische Solarzelle als hintere Teilzelle. Weiterhin ist vorzugsweise bei der organischen Solarzelle das Akzeptormaterial auf der der Farbstoffsolarzelle zugewandten Seite der Teilzelle angeordnet, und das Donatormaterial auf der der Farbstoffsolarzelle abgewandten Seite. Somit ergibt sich, von der Farbstoffsolarzelle aus gesehen, vorzugsweise (in der Halbleitersprache ausgedrückt) innerhalb der organischen Solarzelle ein n-p-Übergang statt eines p-n-Übergangs. Auch andere Aufbauten sind jedoch möglich.

Weiterhin kann der Tandemzellenaufbau grundsätzlich als Vier-Kontakt-Aufbau realisiert sein. Bevorzugt ist jedoch, aufgrund der günstigeren Herstellung, ein Zwei-Kontakt-Aufbau, mit vorzugsweise lediglich zwei Elektroden. Dabei ist vorzugsweise die mit der Farbstoffsolarzelle in Kontakt stehende Elektrode (Arbeitselektrode der Farbstoffsolarzelle) transparent. Vorzugsweise kann die erste (transparente) Elektrode auf einen zumindest teilweise transparenten Träger (z.B. ein Glassubstrat und/oder ein Kunststoffsubstrat, starr oder transparent) aufgebracht sein. Daran kann sich dann die Farbstoffsolarzelle anschließen, gefolgt von der organischen Solarzelle, an welche sich wiederum die (nicht notwendigerweise transparente) zweite Elektrode als Deckelektrode oder Topelektrode anschließt. Das in elektrische Energie umzuwandelnde Licht tritt dann durch den transparenten Träger zunächst in die Farbstoffsolarzelle ein, wird dort teilweise absorbiert (insbesondere von dem Farbstoff), tritt dann in die organische Solarzelle ein und wird dort erneut (vorzugsweise in einem zumindest teilweise verschiedenen Spektralbereich) zumindest teilweise absorbiert (von mindestens einem der organischen Materialien, also vom Akzeptormaterial und/oder vom Donatormaterial und/oder von einem separaten Absorber, beispielsweise einem eindotierten Absorber). Auch andere Schichtaufbauten sind jedoch denkbar, beispielsweise invertierte Aufbauten.

Der vorgeschlagene Aufbau weist gegenüber bekannten photovoltaischen Elementen eine Reihe von Vorteilen auf. So kann insbesondere langwelliges Licht von der organischen Solarzelle besser genutzt werden, indem eine entsprechende Auswahl von Donator- und Akzeptormaterialien getroffen wird. Insbesondere kann das Donator-und/oder Akzeptormaterial derart gewählt werden, dass dieses im nahen Infrarotbereich (NIR) absorbiert. Dies kann zu einer besseren Ausnutzung des Sonnenspektrums und damit zu einem besseren Wirkungsgrad führen. Insbesondere können beide Teilzellen derart gewählt werden, dass diese komplementär absorbieren, wodurch sich stark erhöhte Wirkungsgrade erzielen lassen. So ist es insbesondere bevorzugt, wenn der Farbstoff der Farbstoffsolarzelle eine Absorption im Bereich zwischen 400 nm und 700 nm aufweist, wohingegen es bevorzugt ist, wenn das Akzeptormaterial und/oder das Donatormaterial der organischen Solarzelle derart gewählt sind, dass diese eine Absorption im Bereich zwischen 600 nm und 1000 nm aufweisen. Diese Wahl ist insbesondere deshalb bevorzugt, da die Farbstoffsolarzellen in der Regel sehr dünn ausgestaltet sein müssen (typischerweise 1-2,5 Mikrometer), wodurch diese das gesamte einfallende Licht nicht immer vollständig ausnutzen können. Gerade dieser langwellige, nur wenig genutzte Anteil des Spektrums kann bei der genannten Wahl der Absorption der organischen Solarzelle durch den Tandemzellenaufbau effizient genutzt werden, was die Gesamteffizienz des Aufbaus deutlich erhöhen kann.

Weiterhin liegt ein Vorteil des vorgeschlagenen Aufbaus, insbesondere der Verwendung eines "Festelektrolyten" mit einem p-Halbleiter anstelle eines flüssigen oder gelförmigen Elektrolyten, darin, dass die Teilströme der beiden Teilzellen vergleichsweise einfach aufeinander abgestimmt werden können. Wie oben beschrieben, liegt ein Nachteil bekannter Zwei-Kontakt-Tandemzellen darin, dass die Teilzelle mit dem kleineren Strom den Gesamtstrom limitiert. Mit dem vorgeschlagenen Aufbau lassen sich jedoch (beispielsweise durch Einstellen der Materialparameter, Auswahl geeigneter Absorber und/oder Einstellen der Schichtdicken) die Ströme der beiden Teilzellen vergleichsweise einfach einstellen. Auf diese Weise lässt sich ein effizientes Element erzeugen, bei dem sich die Photospannungen beider Teilzellen zu einer hohen Gesamtspannung addieren. Weiterhin vermeidet der vorgeschlagene Zellenaufbau auch die oben aufgeführten Nachteile der aus dem Stand der Technik bekannten, doppelt mit Farbstoff sensibilisierten, einen flüssigen Elektrolyten verwendenden Tandemzellenkonzepte von He, Hagfeldt et al. und von Nakasa et al. und ermöglicht einen erheblich vereinfachten Zellaufbau, welcher beispielsweise auch produktionstechnisch in einer einzelnen geschlossenen Linie realisierbar ist. So lässt sich insbesondere der bei Hagfeldt et al. beschriebene Aufbau, welcher eine doppelte Farbstoffsensibilisierung erfordert (sensibilisierte Oxidanode und sensibilisierte Oxidkathode), vermeiden.

Der oben vorgeschlagene Grundaufbau lässt sich auf verschiedene Weisen vorteilhaft ausgestalten oder erweitern. Diese Erweiterungen sind teilweise in den Unteransprüchen dargestellt, wobei einige der bevorzugten Möglichkeiten im Folgenden beschrieben werden sollen. Für weitere mögliche Einzelheiten kann auf die nachfolgenden Beispiele verwiesen werden sowie auf die in dem eingangs beschrieben Stand der Technik dargestellten Materialien und Techniken.

### 1. Die Farbstoffsolarzelle

### Erste Elektrode und n-halbleitendes Metalloxid

Als n-halbleitendes Metalloxid der Farbstoffsolarzelle kann ein einzelnes Metalloxid oder eine Mischung verschiedener Oxide eingesetzt werden. Auch eine Verwendung von Mischoxiden ist möglich. Das n-halbleitende Metalloxid kann insbesondere als nanopartikuläres Oxid eingesetzt werden, wobei unter Nanopartikeln in diesem Zusammenhang Partikel zu verstehen sind, welche eine durchschnittliche Partikelgröße von weniger als 0,1 Mikrometern aufweisen.

Ein nanopartikuläres Oxid wird üblicherweise durch einen Sinterprozess als dünner poröser Film mit großer Oberfläche auf ein leitfähiges Substrat (d.h. ein Träger mit einer leitfähigen Schicht als erster Elektrode) aufgebracht.

Als Substrat (im Folgenden auch Träger genannt) eignen sich neben Metallfolien vor allem Kunststoffplatten oder -folien und insbesondere Glasplatten. Als Elektrodenmaterial, insbesondere für die erste Elektrode gemäß dem oben beschriebenen, bevorzugten Aufbau, eignen sich insbesondere leitfähige Materialien wie z.B. transparente leitfähige Oxide (Transparent Conducting Oxide, TCO), beispielsweise mit Fluor und/oder Indium dotiertes Zinnoxid (FTO bzw. ITO) und/oder Aluminium-dotiertes Zinkoxid (A-ZO), Kohlenstoffnanoröhren oder Metallfilme. Alternativ oder zusätzlich könnten jedoch auch dünne Metallfilme, die noch eine ausreichende Transparenz aufweisen, eingesetzt werden. Das Substrat kann mit diesen leitfähigen Materialien belegt bzw. beschichtet sein.

Da bei dem vorgeschlagenen Aufbau in der Regel nur ein einzelnes Substrat benötigt wird, ist auch der Aufbau flexibler Zellen möglich. Dies ermöglicht eine Vielzahl von Einsatzzwecken, die mit starren Substraten nicht oder nur schlecht realisierbar wären, wie beispielsweise den Einsatz in Bankkarten, Kleidungsstücken etc.

Die erste Elektrode, insbesondere die TCO-Schicht, kann zusätzlich mit einer (beispielsweise 10 bis 200 nm dicken) festen Pufferschicht, insbesondere einer Metalloxid-Pufferschicht, belegt oder beschichtet werden, um einen direkten Kontakt des p-Halbleiters mit der TCO-Schicht zu vermeiden (siehe Peng et al., Coord. Chem. Rev. 248, 1479 (2004)). Das Puffer-Metalloxid, welches in der Pufferschicht eingesetzt werden kann, kann beispielsweise eines oder mehrere der folgenden Materialien umfassen: Vanadiumoxid; ein Zinkoxid; ein Zinnoxid; ein Titanoxid. Die erfindungsgemäße Verwendung fester p-halbleitender Elektrolyte, bei welcher ein Kontakt des Elektrolyten mit der ersten Elektrode im Vergleich zu flüssigen oder gelförmigen Elektrolyten stark verringert ist, macht diese Pufferschicht jedoch in vielen Fällen unnötig, so dass auf diese Schicht, welche auch eine strombegrenzende Wirkung hat und auch den Kontakt des n-halbleitenden Metalloxids mit der ersten Elektrode verschlechtern kann, in vielen Fällen verzichtet werden kann. Dies steigert die Effizienz der Bauelemente. Andererseits kann eine derartige Pufferschicht wiederum gezielt genutzt werden, um den Teilstrom der Farbstoffsolarzelle auf den Teilstrom der organischen Solarzelle anzupassen. Weiterhin treten bei Zellen, in denen auf die Pufferschicht verzichtet wurde, insbesondere in Feststoffzellen, häufig Probleme mit unerwünschten Rekombinationen von Ladungsträgern auf. Insofern sind Pufferschichten gerade in Feststoffzellen in vielen Fällen von Vorteil.

Dünne Schichten oder Filme von Metalloxiden stellen bekanntermaßen in der Regel kostengünstige feste Halbleitermaterialien (n-Halbleiter) dar, jedoch liegt ihre Absorption aufgrund großer Bandlücken üblicherweise nicht im sichtbaren Bereich des elektromagnetischen Spektrums, sondern zumeist im ultravioletten Spektralbereich. Für die Anwendung in Solarzellen müssen die Metalloxide daher in der Regel, wie dies bei den Farbstoffsolarzellen der Fall ist, mit einem Farbstoff als Photosensibilisator kombiniert werden, der im Wellenlängenbereich des Sonnenlichts, also bei 300 bis 2000 nm, absorbiert und im elektronisch angeregten Zustand Elektronen in das Leitungsband des Halbleiters injiziert. Mithilfe eines zusätzlich in der Zelle eingesetzten festen p-Halbleiters als Elektrolyt, der wiederum an der Gegenelektrode (bzw. bei einer Tandemsolarzelle am Übergang zur zweiten Teilzelle) reduziert wird, können Elektronen zum Sensibilisator zurückgeführt werden, so dass dieser regeneriert wird.

Von besonderem Interesse für die Anwendung in Solarzellen sind die Halbleiter Zinkoxid, Zinndioxid, Titandioxid oder Mischungen dieser Metalloxide. Die Metalloxide können in Form nanokristalliner poröser Schichten zum Einsatz kommen. Diese Schichten weisen eine große Oberfläche auf, die mit dem Sensibilisator beschichtet wird, so dass eine hohe Absorption des Sonnenlichts erreicht wird. Metalloxid-Schichten, die strukturiert sind, wie z.B. Nanostäbchen (Nanorods), bieten Vorteile wie höhere Elektronmobilitäten oder verbesserte Porenfüllung durch den Farbstoff.

Die Metalloxidhalbleiter können allein oder in Form von Mischungen eingesetzt werden. Es ist auch möglich, ein Metalloxid mit einem oder mehreren anderen Metalloxiden zu beschichten. Weiterhin können die Metalloxide auch als Beschichtung auf einem anderen Halbleiter, z.B. GaP, ZnP oder ZnS, aufgebracht sein.

Besonders bevorzugte Halbleiter sind Zinkoxid und Titandioxid in der Anatas-Modifikation, das vorzugsweise in nanokristalliner Form eingesetzt wird.

Außerdem können die Sensibilisatoren vorteilhaft mit allen n-Halbleitern, die üblicherweise in diesen Solarzellen Verwendung finden, kombiniert werden. Als bevorzugte Beispiele seien in der Keramik eingesetzte Metalloxide, wie Titandioxid, Zinkoxid, Zinn(IV)-oxid, Wolfram(VI)oxid, Tantal(V)oxid, Niob(V)oxid, Caesiumoxid, Strontiumtitanat, Zinkstannat, komplexe Oxide vom Perowskit-Typ, z.B. Bariumtitanat, und binäre und ternäre Eisenoxide genannt, die auch in nanokristalliner oder amorpher Form vorliegen können.

Aufgrund der starken Absorption, welche übliche organischen Farbstoffe sowie Phthalocyanine und Porphyrine aufweisen, sind bereits dünne Schichten oder Filme des n-halbleitenden Metalloxids ausreichend, um die erforderliche Menge an Farbstoff aufzunehmen. Dünne Metalloxidfilme haben wiederum den Vorteil, dass die Wahrscheinlichkeit unerwünschter Rekombinationsprozesse sinkt und dass der innere Widerstand der Farbstoff-Teilzelle reduziert wird. Für das n-halbleitende Metalloxid lassen sich bevorzugt Schichtdicken von 100 nm bis hin zu 20 Mikrometern einsetzen, besonders bevorzugt im Bereich zwischen 500 nm bis ca. 3 Mikrometern.

### Farbstoff

Zahlreiche Farbstoffe, die im Rahmen der vorliegenden Erfindung einsetzbar sind, sind aus dem Stand der Technik bekannt, so dass für mögliche Materialbeispiele auch auf die obige Beschreibung des Standes der Technik zu Farbstoffsolarzellen verwiesen werden kann. Alle aufgeführten und beanspruchten Farbstoffe können grundsätzlich auch als Pigmente vorliegen. Farbstoffsensibilisierte Solarzellen, die auf Titandioxid als Halbleitermaterial basieren, sind z.B. in US-A-4 927 721, Nature 353, S. 737-740 (1991) und US-A-5 350 644 sowie Nature 395, S. 583-585 (1998) und EP-A-1 176 646 beschrieben. Die in diesen Schriften beschriebenen Farbstoffe lassen sich grundsätzlich auch vorteilhaft im Rahmen der vorliegenden Erfindung einsetzen. Diese Farbstoffsolarzellen enthalten monomolekulare Filme aus Übergangsmetallkomplexen, insbesondere Rutheniumkomplexen, die über Säuregruppen an die Titandioxidschicht gebunden sind, als Sensibilisatoren.

Als Sensibilisatoren wurden nicht zuletzt aus Kostengründen auch wiederholt metallfreie organische Farbstoffe vorgeschlagen, welche auch im Rahmen der vorliegenden Erfindung einsetzbar sind. Hohe Wirkungsgrade von über 4%, insbesondere in Feststoff-Farbstoffsolarzellen, lassen sich beispielsweise mit Indolinfarbstoffen erzielen (siehe z.B. Schmidt-Mende et al., Adv. Mater. 2005, 17, 813). US-A-6 359 211 beschreibt die auch im Rahmen der vorliegenden Erfindung einsetzbare Verwendung von Cyanin-, Oxazin-, Thiazin- und Acridinfarbstoffen, die über einen Alkylenrest gebundene Carboxylgruppen zur Fixierung an den Titandioxidhalbleiter aufweisen.

In den JP-A-10-189065, 2000-243463, 2001-093589, 2000-100484 und 10-334954 werden verschiedene im Perylengerüst unsubstituierte Perylen-3,4:9,10-tetracarbonsäurederivate für die Anwendung in Halbleitersolarzellen beschrieben. Im Einzelnen handelt es sich um: Perylentetracarbonsäuredümide, die an den Imidstickstoffatomen Carboxyalkyl-, Carboxyaryl-, Carboxyarylalkyl- oder Carboxyalkylarylreste tragen und/oder mit p-Diaminobenzolderivaten imidiert sind, bei denen das Stickstoffatom der Aminogruppe in p-Stellung durch zwei weitere Phenylreste substituiert oder Bestandteil eines heteroaromatischen tricyclischen Systems ist; Perylen-3,4:9,10-tetracarbonsäuremonoanhydridmonoimide, die am Imidstickstoffatom die vorstehend genannten Reste oder nicht weiter funktionalisierte Alkyl- oder Arylreste tragen, oder Semikondensate von Perylen-3,4,9,10-tetracarbonsäuredianhydrid mit 1,2-Diaminobenzolen oder 1,8-Diaminonaphthalinen, die durch weitere Reaktion mit primärem Amin in die entsprechenden Diimide bzw. doppelten Kondensate überführt werden; Kondensate von Perylen-3,4,9,10-tetracarbonsäuredianhydrid mit 1,2-Diaminobenzolen, die durch Carboxyl- oder Aminoreste funktionalisiert sind; sowie Perylen-3,4:9,10-tetracarbonsäurediimide, die mit aliphatischen oder aromatischen Diaminen imidiert sind.

In New J. Chem. 26, S. 1155-1160 (2002) wird die Sensibilisierung von Titandioxid mit Perylenderivaten untersucht, die im Perylengerüst (bay-Positionen) nicht substituiert sind. Im Einzelnen genannt werden 9-Dialkylaminoperylen-3,4-dicarbonsäureanhydride, Perylen-3,4-dicarbonsäureimide, die in 9-Stellung durch Dialkylamino oder Carboxymethylamino substituiert sind und am Imidstickstoffatom einen Carboxymethyl- bzw. einen 2,5-Di(tert.-butyl)phenylrest tragen, und N-Dodecylaminoperylen-3,4:9,10-tetracarbonsäuremonoanhydridmonoimid genannt. Die Flüssigelektrolytsolarzellen auf Basis dieser Perylenderivate zeigten jedoch wesentlich geringere Wirkungsgrade als eine zum Vergleich mit einem Rutheniumkomplex sensibilisierte Solarzelle.

Besonders bevorzugt als Sensibilisatorfarbstoffe in der vorgeschlagenen Farbstoffsolarzelle sind die in DE 10 2005 053 995 A1 oder WO 2007/054470 A1 beschriebenen Perylenderivate, Terrylenderivate und Quaterrylenderivate. Die Verwendung dieser Farbstoffe führt zu photovoltaischen Elementen mit hohen Wirkungsgraden und gleichzeitig hohen Stabilitäten.

Die Rylene zeigen starke Absorption im Wellenlängenbereich des Sonnenlichts und können dabei in Abhängigkeit von der Länge des konjugierten Systems einen Bereich von etwa 400 nm (Perylenderivate I aus DE 10 2005 053 995 A1) bis zu etwa 900 nm (Quaterrylenderivate I aus DE 10 2005 053 995 A1) abdecken. Rylenderivate I auf Terrylenbasis absorbieren je nach ihrer Zusammensetzung in festem, an Titandioxid adsorbiertem Zustand in einem Bereich von etwa 400 bis 800 nm. Um eine möglichst weitgehende Nutzung des eingestrahlten Sonnenlichts vom sichtbaren bis in den nahinfraroten Bereich zu erreichen, ist es vorteilhaft, Mischungen verschiedener Rylenderivate I einzusetzen. Gelegentlich kann es sich auch empfehlen, dabei auch verschiedenen Rylenhomologe zu verwenden.

Die Rylenderivate I können leicht und dauerhaft auf dem Metalloxidfilm fixiert werden. Die Bindung erfolgt dabei über die Anhydridfunktion (x1) bzw. die in situ gebildeten Carboxylgruppen -COOH bzw. -COO- oder über die in den Imid- oder Kondensatresten ((x2) bzw. (x3)) enthaltenen Säuregruppen A. Die in der DE 10 2005 053 995 A1 beschriebenen Rylenderivate I eignen sich gut für den Einsatz in farbstoffsensibilisierten Solarzellen im Rahmen der vorliegenden Erfindung.

Besonders bevorzugt ist es wenn die Farbstoffe an einem Molekülende eine Ankergruppe aufweisen, die ihre Fixierung am n-Halbleiterfilm gewährleistet. Am anderen Molekülende enthalten die Farbstoffe vorzugsweise Elektronendonatoren Y, die die Regeneration des Farbstoffs nach der Elektronenabgabe an den n-Halbleiter erleichtern und außerdem die Rekombination mit bereits an den Halbleiter abgegebenen Elektronen verhindern.

Für weitere Details zur möglichen Auswahl eines geeigneten Farbstoffs kann beispielsweise wiederum auf die DE 10 2005 053 995 A1 verwiesen werden. Für die vorliegend beschriebenen Tandemzellen können insbesondere Ruthenium-Komplexe, Porphyrine, andere organische Sensibilisatoren und bevorzugt Rylene eingesetzt werden.

Die Fixierung der Farbstoffe auf den Metalloxidfilmen kann in einfacher Weise erfolgen. Beispielsweise können die n-halbleitenden Metalloxidfilme in frisch gesintertem (noch warmem) Zustand über einen ausreichenden Zeitraum (z.B. etwa 0,5 bis 24 h) mit einer Lösung oder Suspension des Farbstoffs in einem geeigneten organischen Lösungsmittel in Kontakt gebracht werden. Dies kann beispielsweise durch Eintauchen des mit dem Metalloxid beschichteten Substrats in die Lösung des Farbstoffs geschehen.

Sollen Kombinationen verschiedener Farbstoffe eingesetzt werden, so können diese beispielsweise aus einer oder mehreren Lösungen oder Suspensionen, die einen oder mehrere der Farbstoffe enthalten, nacheinander aufgebracht werden. Auch möglich ist der Einsatz von zwei Farbstoffen, die getrennt durch eine Schicht von z.B. CuSCN sind (siehe hierzu z.B. Tennakone, K. J., Phys. Chem B. 2003, 107, 13758). Die zweckmäßigste Methode kann im Einzelfall vergleichsweise leicht ermittelt werden.

Bei der Auswahl des Farbstoffs sowie der Größe der Oxidpartikel sollte die Solarzelle so gestaltet sein, dass möglichst viel Licht von beiden Teilzellen absorbiert wird. Daher sollten die Farbstoffe, wie oben bereits beschrieben, möglichst komplementär gewählt werden. Die Oxidschichten sollten dabei so strukturiert sein, dass der feste p-Halbleiter die Poren gut füllen kann.

Grundsätzlich kann der Farbstoff als getrenntes Element vorliegen oder in einem getrennten Schritt aufgebracht werden und getrennt auf die übrigen Schichten aufgebracht werden. Alternativ oder zusätzlich kann der Farbstoff jedoch auch mit einer oder mehreren der anderen Elemente zusammengefasst werden bzw. gemeinsam aufgebracht werden, beispielsweise mit dem festen p-Halbleiter. So kann beispielsweise eine Farbstoff-p-Halbleiter-Kombination verwendet werden, welche einen absorbierenden Farbstoff mit p-halbleitenden Eigenschaften umfasst oder beispielsweise ein Pigment mit absorbierenden und p-halbleitenden Eigenschaften.

Wie oben beschrieben, weist das vorgeschlagene Tandemzellenkonzept die Verwendung eines oder mehrerer fester p-Halbleiter auf. Zusätzlich zu dem bzw. den festen p-Halbleitern können natürlich auch weitere Materialien mit ähnlichen Eigenschaften, beispielsweise Festelektrolyte, vorgesehen sein, wobei jedoch eine ausschließliche Verwendung des mindestens einen festen p-Halbleiters bevorzugt ist. Um eine Rekombination der Elektronen in dem n-halbleitenden Metalloxid mit dem festen p-Leiter zu verhindern, kann eine Art passivierende Schicht einsetzen, welche ein Passivierungsmaterial aufweist. Diese Schicht sollte möglichst dünn sein und sollte möglichst nur die bisher unbedeckten Stellen des n-halbleitenden Metalloxids bedecken. Das Passivierungsmaterial kann unter Umständen auch zeitlich vor dem Farbstoff auf das Metalloxid aufgebracht werden. Als Passivierungsmaterialien werden insbesondere die folgenden Stoffe bevorzugt: Al₂O₃; ein Aluminium-Salz; Silane, wie z.B. CH₃SiCl₃; einen metallorganischen Komplex, insbesondere einen Al³⁺-Komplex; Al³⁺, insbesondere einen Al³⁺-Komplex; 4-tert-Butylpyridin (TBP); MgO; 4-guanidinobutylsäure (GBA); eine Alkylsäure; Hexadecylmalonsäure (HDMA).

### p-Halbleiter

Wie oben beschrieben, werden im Rahmen des hier vorgeschlagenen Tandemkonzeptes feste p-Halbleiter eingesetzt. Feste p-Halbleiter können in den erfindungsgemäßen farbstoffsensibilisierten Teilzellen auch ohne eine große Erhöhung des Zellenwiderstands zum Einsatz kommen, insbesondere wenn die Farbstoffe stark absorbieren und daher nur dünne n-Halbleiterschichten erfordern. Insbesondere sollte der p-Halbleiter im Wesentlichen eine geschlossene, dichte Schicht aufweisen, damit unerwünschte Rekombinationsreaktionen, die sich aus einem Kontakt zwischen dem n-halbleitenden Metalloxid (insbesondere in nanoporöser Form) mit der zweiten Elektrode oder der zweiten Halbzelle ergeben könnten, vermindert werden.

Eine wesentliche, die Auswahl des p-Halbleiters beeinflussende Größe ist die Lochbeweglichkeit, da diese die Lochdiffusionslänge mitbestimmt (vgl. Kumara, G., Langmuir, 2002, 18, 10493-10495). Ein Vergleich von Ladungsträgerbeweglichkeiten in verschiedenen Spiroverbindungen findet sich beispielsweise in Saragi, T., Adv. Funct. Mater. 2006, 16, 966-974.

Beispiele für feste p-Halbleiter sind anorganische Festkörper, wie Kupfer(I)iodid und Kupfer(I)thiocyanat. Bevorzugt werden jedoch organische (d.h. niedermolekulare, oligomere oder polymere Halbleiter oder Mischungen derartiger Halbleiter) Halbleiter verwendet. Beispiele sind hier p-Halbleiter auf der Basis von Polymeren wie Polythiophen und Polyarylaminen, oder von amorphen, reversibel oxidierbaren, nichtpolymeren organischen Verbindungen, wie den eingangs erwähnten Spirobifluorenen (vgl. z.B. US 2006/0049397 und die hierin offenbarten Spiroverbindungen als p-Halbleiter, welche auch im Rahmen der vorliegenden Erfindung einsetzbar sind). Diese festen p-Halbleiter können sowohl in undotierter als auch in dotierter Form eingesetzt werden.

Weiterhin kann auch auf die Ausführungen zu den p-halbleitenden Materialien in der Beschreibung des Standes der Technik verweisen werden. Auch für die übrigen möglichen Elemente und den möglichen Aufbau der Farbstoffsolarzelle kann weitgehend auf die obige Beschreibung verwiesen werden.

### 2. Optionale Ladungsrekombinationszone zwischen Farbstoffsolarzelle und organischer Solarzelle

Da es hier sich bei dem vorgeschlagenen photovoltaischen Element um ein Element nach dem Tandemkonzept handelt, sollte sichergestellt werden, dass Elektronen aus dem n-Halbleiter der organischen Solarzelle mit möglichst geringem Energieverlust mit den Löchern aus dem p-Halbleiter der Farbstoffsolarzelle rekombinieren. Ansonsten können die Ladungsträger entweder nicht miteinander rekombinieren, was zu einem stark unterdrückten Photostrom führt, oder die Spannungsverluste werden sehr groß.

Daher wird in einer bevorzugten Ausgestaltung der Erfindung eine Ladungsrekombinationszone zwischen den beiden Teilzellen eingesetzt, um die Löcher der Farbstoffsolarzelle und Elektronen der organischen Solarzelle aufzufangen. Ein ähnliches Konzept ist in WO 02/101838 beschrieben. Die Ladungsrekombinationszone sollte zumindest in dem Spektralbereich, welcher von der zweiten, in Einstrahlrichtung nachgelagerten Teilzelle überwiegend absorbiert wird, zumindest teilweise transparent sein, damit auch die zweite Teilzelle (z.B. die organische Solarzelle) ausreichend bestrahlt wird. Vorzugsweise sollte diese Ladungsrekombinationszone daher möglichst dünn sein, vorzugsweise dünner als 20 Å (2,0 nm), bevorzugt etwa 5 Å (0,5 nm) dick. Dabei ist es nicht zwingend erforderlich, dass eine homogene Schicht aufgebaut wird, sondern es kann sich beispielsweise bei der Ladungsrekombinationszone auch um ein Inselwachstum handeln, beispielsweise in Form von isolierten Metall-Nanopartikeln. Die Verwendung von Metall-Nanopartikeln in der Ladungsrekombinationszone kann auch den positiven Effekt einer Resonanzüberhöhung und damit einer erhöhten Absorption des angrenzenden aktiven Materials aufweisen (siehe z.B. Rand, B., J. Appl. Phys. 2004, 96, 7519). Als Materialien für die Ladungsrekombinationszone lassen sich vorzugsweise Metalle einsetzen, z.B. Ag, Au, Li, Al, Ti, Sn oder Kombinationen und Legierungen dieser und/oder anderer Metalle, sowie Metalloxide (die auch dotiert sein können) und/oder Metallfluoride, wie beispielsweise LiF, ggf. in Kombination mit einem Metall, wie beispielsweise Al. Alternativ oder zusätzlich könnten auch leitfähige Polymere eingesetzt werden, wie beispielsweise PEDOT (Poly(3,4-ethylendioxythiophen) poly(styrolsulfonat)). Aus den Metalloxiden wird insbesondere WO₃ bevorzugt. Bei den Metallen ist die Verwendung von Silber und/oder Gold bevorzugt, wobei die Verwendung von Silber besonders bevorzugt ist. Auch Kombinationen verschiedener Metalle und/oder Metalloxide und/oder Metallhalogenide lassen sich einsetzen.

Alternativ oder zusätzlich zur gezielten Einbringung von Rekombinationsmaterialien, wie beispielsweise den oben beschriebenen Materialien, lassen sich auch andere Konzepte zur Erzeugung einer Ladungsrekombinationszone verwenden. So lassen sich beispielsweise elektronisch aktive Störstellen einsetzen, die in der Ladungsrekombinationszone zu einer Elektron-Loch-Rekombination führen. Beispielsweise können zu diesem Zweck im Bereich der Ladungsrekombinationszone gezielt begrenzt Defekte in den Schichtaufbau bzw. die Grenzfläche zwischen der Farbstoffsolarzelle und der organischen Solarzelle eingebracht werden. Diese Defekte, welche als elektronisch aktive Störstellen wirken, können beispielsweise durch Erwärmen, durch kontrollierte Einführung von Verunreinigungen, durch Bestrahlung mit hochenergetischer Partikelstrahlung während der Abscheidung der jeweiligen organischen Schichten oder auch durch andere Techniken erfolgen. Auch eine Mikrowellenbestrahlung, eine Plasmabehandlung oder eine Behandlung mit durch Mikrowellen angeregten Teilchen ist möglich. Derartige Verfahren zur gezielten Einführung von Störstellen durch entsprechende Behandlung sind beispielsweise aus der Technik der anorganischen Halbleiterherstellung bekannt und können übernommen werden. Alternativ oder zusätzlich kann die Ladungsrekombinationszone auch einen hochdotierten p/n-Übergang umfassen, das heißt eine Zone umfassen, in welcher die verwendeten Materialien höher dotiert sind als in den übrigen Schichten.

### 3. Die organische Solarzelle

Wie oben beschrieben, schließt sich vorzugsweise an die Farbstoffsolarzelle unmittelbar oder über die Ladungsrekombinationszone die organische Solarzelle an. Vorzugsweise wird, wie ebenfalls oben beschrieben, zunächst die Farbstoffsolarzelle auf dem Träger abgeschieden und anschließend die organische Solarzelle aufgebracht. Die organische Solarzelle wird in diesem Fall (direkt oder nach Aufbringen/Einbringen der Ladungsrekombinationszone) auf der schon bestehenden Farbstoffsolarzelle abgeschieden.

Bei der organischen Solarzelle macht sich der erfindungsgemäße TandemzellenAufbau besonders vorteilhaft bemerkbar, da die organischen Solarzellen aufgrund der Erfordernisse des Ladungs- und/oder Exziton-Transports innerhalb der Schichten üblicherweise sehr dünn ausgestaltet sind. Mit abnehmender Dicke sinkt jedoch auch die Effizienz der Lichtabsorption. Dieser nachteilige Effekt lässt sich wiederum durch das Tandemzellenkonzept vermindern.

Die organische Solarzelle weist mindestens ein Akzeptormaterial (n-Halbleiter) und mindestens ein Donatormaterial (p-Halbleiter) auf, welche an einem p-n-Übergang direkt oder indirekt miteinander in Kontakt stehen, wobei jedoch auch Zwischenschichten (analog zu einem p-i-n-Übergang) bestehen können. Allgemein können bei der organischen Solarzelle anstelle der vorangehend und im Folgenden beschriebenen Schichten und Mehrschichtaufbauten, alternativ oder zusätzlich auch ganz oder teilweise Mischschichten der genannten Materialien eingesetzt werden, also anstelle beispielsweise eines Zweischichtaufbaus mit zwei getrennten Materialien (z.B. Akzeptormaterialschicht und Donatormaterialschicht) eine einzelne Mischmaterialschicht. Auch Übergangsschichten zwischen zwei getrennten Schichten sind möglich, beispielsweise mit einer Akzeptormaterialschicht, einer Zwischenschicht mit einer Mischung eines Akzeptormaterials und eines Donatormaterials (auch hierbei handelt es sich theoretisch um eine Bulk Heterojunction, s.u.) und anschließend einer Donatormaterialschicht. Weiterhin lassen sich auch so genannte "Bulk Heterojunctions" einsetzen, also aus dem Bereich der Solarzellentechnik bekannte Aufbauten, bei denen zwischen zwei Schichten, beispielsweise einer Akzeptormaterialschicht und einer Donatormaterialschicht, eine Grenzschicht mit stark vergrößerter Oberfläche vorgesehen ist. Dabei greifen die einzelnen Schichten entlang der stark unebenen Grenzfläche mit einer Vielzahl von "Bergen" und Tälern" ineinander. Diese Bulk Heterojunction ist insbesondere beim Akzeptor-Donatormaterialaufbau der organischen Solarzelle vorteilhaft einsetzbar.

So kann vorzugsweise die organische Solarzelle einen Übergang zwischen einer Schicht des Akzeptormaterials und einer Schicht des Donatormaterials aufweisen, wobei vorzugsweise die Schicht des Akzeptormaterials auf einer der Farbstoffsolarzelle zugewandten Seite und die Schicht des Donatormaterials auf einer der Farbstoffsolarzelle abgewandten Seite des Übergangs angeordnet ist (n/p-Übergang). Dieser Übergang kann als ein direkter Übergang zwischen einer n-Schicht und einer p-Schicht ausgestaltet sein, kann aber auch zusätzlich eine zwischen der Schicht des Akzeptormaterials und der Schicht des Donatormaterials angeordnete Mischschicht mindestens eines Akzeptormaterials und mindestens eines Donatormaterials (also eine Bulk Heterojunction) aufweisen. Der Übergang und die Schichten dieses Übergangs können beispielsweise ganz oder teilweise in Form von (beispielsweise aus einer Lösung oder Dispersion erzeugten) Polymerschichten und/oder in Form von (vorzugsweise aufgedampften und/oder aus einer Dispersion hergestellten) Pigmenten oder (vorzugsweise aus einer Lösung oder einer Dispersion erzeugten) Farbstoffen, also niedermolekularen organischen Materialien, erzeugt werden.

Mindestens eines der beiden Materialien (Akzeptormaterial und/oder Donatormaterial) sollte elektromagnetische Strahlung, also insbesondere Licht, zumindest teilweise absorbieren. Diese Absorption sollte insbesondere "komplementär" zur Absorption der Farbstoffsolarzelle gewählt werden, also zumindest nicht deckungsgleich. So ist es beispielsweise bevorzugt, wenn die Farbstoffsolarzelle ihre überwiegende Absorption (beispielsweise ein Absorptionsmaximum) in einem kürzeren (also energiereicheren) Wellenlängenbereich aufweist als die organische Solarzelle. So ist es, wie oben beschrieben, bevorzugt, wenn die organische Solarzelle in einem Bereich absorbiert, welcher zwischen 600 nm und 1000 nm liegt (wobei dieser Wellenlängenbereich natürlich nicht vollständig abgedeckt sein muss und wobei natürlich zusätzlich auch Absorptionen in anderen Bereichen vorliegen können), wohingegen die Farbstoffsolarzelle bevorzugt in einem Bereich absorbiert, welcher zwischen 400 nm und 700 nm liegt (auch hier kann natürlich eine unvollständige Abdeckung dieses Bereiches und/oder zusätzlich auch eine Absorption in einem anderen Bereich vorliegen). Auch eine umgekehrte Ausgestaltung ist jedoch grundsätzlich möglich, also eine Ausgestaltung, bei welcher die Farbstoffsolarzelle ihre überwiegende Absorption in einem längeren Wellenlängenbereich aufweist als die organische Solarzelle.

Beim Aufbringen der organischen Solarzelle wird vorzugsweise das Akzeptormaterial (n-Material) zuerst aufgebracht, d.h. beispielsweise in dem oben beschriebenen Aufbau als das der Farbstoffsolarzelle am nächsten liegende Material. Um die organische Solarzelle elektronisch gut mit der Ladungsrekombinationszone zu koppeln, kann mindestens eine Elektrontransportschicht (ETL) zwischen dieser und dem Akzeptormaterial der organischen Solarzelle eingebracht werden. Unter einer Elektrontransportschicht ist dabei allgemein eine Schicht eines oder mehrerer Materialien zu verstehen, welche Elektronen-leitende oder Elektronen-transportierende Eigenschaften aufweisen. Je nach Anforderung kann diese ETL auch n-dotiert werden. Auf das Akzeptormaterial wird dann das Donatormaterial (p-Material) der organischen Solarzelle aufgebracht, wobei auch oft eine Mischschicht aus n- und p- Materialien am Übergang entsteht oder gezielt herbeigeführt wird.

Die Elektrontransportschicht, wobei sinngemäß auch mehrere Elektrontransportschichten vorgesehen sein können, kann insbesondere eines oder mehrere der folgenden Materialien umfassen: ein Triphenylenderivat; 1,3-bis(4-tert-butylphenyl-1,3,4-oxadiazoyl)phenylen (OXD7); 1,3-bis(4-(N,N-dimethylamino)phenyl-1,3,4-oxadiazoyl)phenylen (OXD8); 2-(1-Naphthyl)-5-(p-tert-butylphenyl)-1,3,4-oxadiazol (t-Bu-PNF); ein Titanoxid (TiOx); bathophenanthrolin (BPhen); 2,9-Dimethyl-4,7-diphenyl-1,10-phenanthrolin (BCP); 3-(Biphenyl-4-yl)-4-phenyl-5-(4-tert-butylphenyl)-1,2,4- triazol (TAZ); einen Ruthenium-Komplex.

Alternativ zu einer sequenziellen Abscheidung der Akzeptor- und Donatormaterialien ist es auch möglich, insbesondere bei Verwendung löslicher Materialien, diese Materialien ganz oder teilweise gleichzeitig abzuscheiden und danach beispielsweise zu tempern. Dabei können beispielsweise Pigmente aufgedampft und/oder aus einer Dispersion aufgebracht werden und Farbstoffe bzw. Polymere aus einer Lösung aufgebracht werden. Beispielsweise können zwei aufgedampfte Materialien oder zwei lösliche Materialien eingesetzt werden, wobei es jedoch auch denkbar ist, Kombinationen löslicher und aufgedampfter Materialien zu verwenden.

Grundsätzlich lassen sich in der organischen Solarzelle die organischen Halbleiter einsetzen, die im Stand der Technik beschrieben sind und die teilweise in der Einleitung dargestellt sind. Einige bevorzugte Beispiele werden im Folgenden aufgelistet.

Bei der Einstellung der Schichtdicken von n-Halbleiter und p-Halbleiter und Übergang muss darauf geachtet werden, dass einerseits viel Licht absorbiert wird, während gleitzeitig die meisten Exzitonen zum p-n-Übergang finden, ohne vorher zu zerfallen. Hier gelten die allgemein von den molekularen Solarzellen bekannten Voraussetzungen und Prinzipien.

### Akzeptormaterial

Akzeptormaterialien sind Materialien, in denen die hauptsächlichen Ladungsträger Elektronen sind. Diese haben vorzugsweise hohe Leitfähigkeit für Elektronen im LUMO (LUMO: lowest unoccupied molecular orbital, niedrigstes besetztes Molekülorbital), hohe Stabilität gegenüber negativer Überschussladung (Reduktion), LUMO-Niveaus bzw. Elektronenaffinitäten im geeigneten Energiebereich und gute Injektionseigenschaften von Elektronen in eine geeignete kathodische Elektrode. Für weitere Eigenschaften geeigneter n-Materialien oder Akzeptormaterialien kann beispielsweise auf WO 02/101838 A1 verwiesen werden.

Je nach Substitutionsmuster und Löslichkeit können mehrere Beispielmaterialien entweder aus der Lösung und/oder Dispersion oder aus dem Vakuum aufgebracht werden. Besonders zu nennen sind hier die Rhodamine und die Triphenylmethane. Sämtliche hier und im Folgenden genannten Materialien können ganz oder teilweise als Farbstoffe und/oder als Pigmente vorliegen, wobei Farbstoffe in der Regel aus einer Lösung aufgebracht werden, wohingegen Pigmente in vielen Fällen im Vakuum aufgebracht werden.

Weiterhin lassen sich, alternativ oder zusätzlich, auch Fullerene einsetzen. Diese können aus einer Vielzahl von Größen (Anzahl der Kohlenstoffatome pro Molekül) ausgewählt sein. Der Begriff "Fullerene", wie er hier verwendet wird, umfasst verschiedene käfigartige Moleküle reinen Kohlenstoffs, einschließlich des Buckminsterfullerenes (C₆₀) und der verwandten "sphärischen" Fullerene, sowie Kohlenstoffnanoröhrchen. Es sind grundsätzlich Fullerene im Bereich von C₂₀ bis C₂₀₀₀ einsetzbar, wobei der Bereich C₆₀-C₉₆ bevorzugt ist, besonders C₆₀ und C₇₀. Es lassen sich auch Fullerene einsetzen, die chemisch modifiziert sind, wie z.B. PCBM ([6,6]-Phenyl-C₆₁-buttersäuremethylester), bis-Morpholin-C₆₀ (BM-C₆₀), C₇₁-PCBM, C₆₀-P N-Methylfullerenpyrrolidin oder Mischungen dieser Fullerene. Fullerene (z.B. C₆₀) zeichnen sich insbesondere durch eine hohe Exzitonendiffusionslänge aus (z. B. etwa 80 Å für C60, vgl. Petterson et al., J. Appl. Phys., 1999, 86, 487.)

Weiterhin lassen sich auch anorganische Nanostäbchen einsetzen und/oder Quantenpunktmaterialien (Quantum Dots), wie beispielsweise Cadmiumselenid (CdSe), Cadmiumtellurid (CdTe), CdS, HgTe, PbS, CulnS₂ oder ähnliche Materialien oder Materialkombinationen.

Weiterhin lassen sich auch andere anorganische Halbleitermaterialien einsetzen, vorzugsweise in Kombination mit einem organischen Material. So lassen sich insbesondere Zinkoxid, Zinnoxid und TiO₂ einsetzen, welche vorzugsweise als Partnermaterialien für organische Materialien eingesetzt werden. Diese können nanopartikulär und/oder auch als Nanostäbchen (Nanorods) vorliegen.

Weiterhin sind als oder in den Akzeptormaterialien auch Kohlenstoffnanoröhrchen (Carbon Nanotubes, NT) einsetzbar. Dabei können einwandige Nanoröhrchen (Single Wall Carbon Nanotubes, SWNTs) oder auch mehrwandige Nanoröhrchen (Multiwall Carbon Nanotubes, MWNTs) verwendet werden.

Weiterhin lassen sich auch n-halbleitende Polymere einsetzen sowie (alternativ oder zusätzlich) LBG-Polymere, d.h. "low bandgap-Polymere", also Polymere mit kleiner Bandlücke, wie beispielsweise CN-PPV.

Besonders bevorzugt ist jedoch die Verwendung von Rylen- und Rylentetracarbonsäure-Farbstoffen oder Rylenmonoimide wie beispielsweise Napthalin, Perylen, Terrylen, Quaterrylen, Pentarylen, Hexarylen, Heptarylen u. Octarylen oder Pigmenten wie z.B. Napthalen, Perylen, Terrylen, Quaterrylen, Pentarylen, Hexarylen, Heptarylen, Octarylen oder Mischungen, Verbindungen oder Derivaten dieser Materialien. Zudem können auch Perylentetracarbonsärebisimidazol (PTCBI) und auch die Pyrimidine eingesetzt werden. Weiterhin lassen sich auch Flüssigkristallinderivate einsetzen, wie beispielsweise entsprechende Derivate des Perylens, Terrylens oder Quaterrylens, wie beispielsweise die in Müllen et al. Chem. Mater. 2006, 18, 3715-3725. beschriebenen Verbindungen. Besonders bevorzugt ist, alternativ oder zusätzlich, auch die Verwendung der in WO 2007/006717 A1 beschrieben substituierten Rylenderivate, der in WO 2006/117383 A1 beschrieben Terrylen- und/oder Quaterrylenderivate und/oder der in WO 2006/111511 A1 dargestellten Pentarylen- und/oder Hexarylen-Derivate.

Insbesondere lassen sich folgende Pigmente einsetzen: 3,4,9,10-Perylentetracarbonsäurebisimidbenzimidazol (PTCBI), Perylentetracarbonsäurebisimidbisanhydrid (PTCBA), Me-PTCDI, Ethylphenyl-PTCBI, oder Kombinationen dieser und/oder anderer Materialien. Auch tetrabrom- und tetrachlorsubstituierte Perylentetracarbonsäurediimide sind geeignete Akzeptormaterialien bzw. n-Halbleiter.

### Donatormaterialien

Donatormaterialien (p-Halbleiter) sind Materialien, in denen die hauptsächlichen Ladungsträger Löcher oder Defektelektronen (bzw. deren organische Leitungspendants) sind. Diese Materialien haben vorzugsweise eine hohe Leitfähigkeit von Löchern (Defektelektronen) im HOMO (HOMO: highest occupied molecular orbital, höchstes besetztes Molekülorbital), hohe Stabilität gegenüber positiver Überschussladung (Oxidation), HOMO Niveaus bzw. lonisationspotenziale im geeigneten Energiebereich, sowie gute Injektionseigenschaften von Löchern in eine geeignete anodische Elektrode. Für weitere Eigenschaften geeigneter p-Materialien oder Donatormaterialien kann beispielsweise auf WO 02/101838 A1 verwiesen werden.

Insbesondere lassen sich als Donatormaterialien Pentacene einsetzen, sowie Phthalocyanin (Pc)-Pigmente. Dabei können die Phthalocyanine substituiert oder nicht substituiert sein. Bevorzugt sind dabei symmetrisch substituierte, also unsubstituierte, 8-fach oder 16-fach substituierte Phthalocyanine, aber auch 4-fach substituierte Pcs könnten unter Umständen geeignet sein. Die Phthalocyanine können metallhaltig oder metallfrei sein. Besonders bevorzugt sind CuPc, ZnPc, 4F-ZnPc, SnPc, Vanadylphthalocyanin (VOPc), H₂Pc, TiOPc oder Mischungen oder Derivate dieser Pcs. Es können unter Umständen auch Subphthalocyanine verwendet werden, wie sie beispielsweise in Forrest, Thompson, JACS 2006, 128, 8108-8109 beschrieben sind.

Neben den (in Lösungsmitteln zumindest im Wesentlichen unlöslichen) Phthalocyanin-Pigmenten lassen sich, alternativ oder zusätzlich, auch Phthalocyanin-Farbstoffe einsetzen, die sich aus der Lösung verarbeiten lassen. Als Beispiel kann hier Flüssigkristall-Ethynyl-substituiertes Ni(II)Pc genannt werden, wie es beispielsweise in Chem. Commun., 2006, 3107 oder in WO 2005/076383 beschrieben ist. Auch andere LC-Pc-Farbstoffe sind einsetzbar.

Weiterhin lassen sich auch Porphyrine einsetzen, wie z.B. 5,10,15,20-tetra(3-pyridyl)porphyrin (TpyP), sowie Merocyanine.

Auch Flüssigkristallmaterialien sind einsetzbar, wie beispielsweise Hexabenzocoronene (HBC-PhC12) oder andere Coronene, Coronendiimide, oder Triphenylene wie 2,3,6,7,10,11-Hexahexylthiotriphenylen (HTT6) oder 2,3,6,7,10,11-hexa-(4-n-Nonylphenyl)-triphenylen (PTP9), 2,3,6,7,10,11-hexa-(Undecyloxy)-triphenylen (HAT11). Insbesondere lassen sich Flüssigkristallmaterialien einsetzen, welche diskotisch sind. Auch 2,3,9,10,16,17,23,24-octa(2-Benzyloxyethylsulfanyl)phthalocyanatokupfer(II) (DL-CuPc) oder andere Pcs mit Alkyl, Alkoxy oder Thioalkoxyketten lassen sich einsetzen, welche diskotische Flüssigkristallmaterialien sind.

Weiterhin lassen sich auch Thiophene einsetzen, sowie Thiophen-haltige Verbindungen und Thiophenderivate. Insbesondere lassen sich Thiophen-haltige niedermolekulare definierte Verbindungen, Thiophen-haltige Oligomere (mit oder ohne Seitenketten, welche die Löslichkeit beeinflussen) oder Thiophengruppen enthaltende Polymere einsetzen, wie z. Bsp. Poly-3-hexylthiophen oder Verbindungen des Typs α,α'-bis(2,2-Dicyanovinyl)quinquethiophen (DCV5T), P3HT, (3-(4-Octylphenyl)-2,2'bithiophen) (PTOPT), (PEOPT), (Poly(3-(2'methoxy-5'-octylphenyl)thiophen))(POMeOPT), Poly(3-octylthiophen) (P3OT), EHH-PpyPz, Copolymere wie z.B. PTPTB oder PCPDTBT (siehe z.B. Brabec C., Adv. Mater., 2006, 18, 2884) oder Poly[2,6-(4,4-bis-(2-ethylhexyl)-4H-cyclopenta[2,1-b;3,4-b']-dithiophen-alt-4,7-(2,1,3-benzothiadiazol)].

Weiterhin lassen sich auch Derivate und Oligomere oder Polymere des Paraphenylenvinylens als Donatormaterialien einsetzen. insbesondere kommen hier para-Phenylenvinylen enthaltende Oligomere oder Polymere in Betracht, wie z.B. Polyparaphenylenvinylen (PPV), Poly(2-methoxy-5-(2'ethylhexyloxy)-1,4-phenylen-vinylen (MEH-PPV), Poly(2-methoxy-5-(3',7'-dimethyloctyloxy)-1,4-phenylen-vinylen) (MDMO-PPV), sowie CN-PPV, ggf. mit verschiedenen Alkoxy-Derivaten, PPE-PPV oder auch Hybrid-Polymere.

Weiterhin lassen sich auch Polyfluorene und alternierende Polyfluoren-Copolymere einsetzen, wie z.B. Copolymere mit 4,7-Dithien-2'-yl-2,1,3-benzothiadiazol, sowie F8BT (ein Polyfluoren-Copolymer) und/oder PFB.

Weiterhin lassen sich auch (2,7) und (3,6) Polycarbazole oder Carbazol-enthaltende Oligomere und Polymere einsetzen.

Weiterhin lassen sich auch (2,7) und (3,6) Polyaniline und/oder Anilin-enthaltende Oligomere und Polymere einsetzen.

Auch Verbindungen aus der Klasse der Triarylamine wie TPD (triphenyldiamin) oder Spiro-MeOTAD oder auch ähnliche Verbindungen, Benzidin-Derivate, CBP, Polytriarylamine, Polycyclopentadiene, Polypyrrole, Polyfurane, Polysilole, Polyphosphole sind einsetzbar.

Auch Rylenderivate können eingesetzt werden, sofern diese durch entsprechende Substituenten Donatoreigenschaften tragen.

Weiterhin sind wiederum auch Fullerene einsetzbar, wie beispielsweise C₆₀ und seine Derivate, wie beispielsweise [6,6]-Phenyl-C₆₁ buttersäuremethylester (PCBM). In diesem Fall würde das Fullerenderivat als Lochleiter eingesetzt.

Weiterhin lassen sich Kupfer(I)iodid und Kupfer(I)thiocyanat einsetzen.

Die Donatormaterialien und/oder auch die Akzeptormaterialien können auch in dotierter Form vorliegen bzw. verwendet werden. Beispiele von p-Dotierstoffen sind insbesondere Br₂, WO₃ MoO₃, F4-TCNQ (Tetrafluor-7,7,8,8-Tetracyanoquinodimethan). Beispiele von n-Dotierstoffen sind insbesondere Cs, Cs₂CO₃, Pyronin B.

Weiterhin können, wie oben beschrieben, auch p-n-Mischmaterialien eingesetzt werden, insbesondere als Zwischenschicht. So können Donatormaterial und Akzeptormaterial in einem einzigen Material vorliegen, also beispielsweise in einem Monomer, Oligomer, Polymer, Blockpolymer, einem Polymer mit C₆₀S, C₆₀-azo-Farbstoff, Triaden Carotenoid-Porphyrin-Chinone. Weiterhin können auch Flüssigkristall-Donator-Akzeptor-Systeme eingesetzt werden, wie diese beispielsweise in Kelly, S., Adv. Mater. 2006, 18, 1754 beschrieben sind.

### Optionale Blockierschicht

Weiterhin ist es bevorzugt, wenn die organische Solarzelle mindestens eine Blockierschicht aufweist. Eine derartige Blockierschicht kann beispielsweise verhindern, dass sich (beim Aufbringen der Schichten oder auch später im Betrieb des Elementes) die Materialien durchmischen und die Bauelementeigenschaften so verschlechtern. Im Rahmen der vorliegenden Erfindung ist es bevorzugt, mindestens eine derartige Blockierschicht zwischen einem Elektrodenmaterial, insbesondere einem Elektrodenmaterial der zweiten Elektrode (beispielsweise der Topelektrode) und einem weiteren Material der organischen Solarzelle einzufügen. Beispielsweise kann die Blockierschicht zwischen der zweiten Elektrode und einem Donatormaterial (p-Absorber, p-Halbleiter) der organischen Solarzelle eingefügt sein, insbesondere um ein Eindringen von Elektrodenmaterialien in das Donatormaterial zu verhindern. Derartige Effekte und Blockierschichten sind beispielsweise aus WO 02/101838 bekannt. Als Materialien für eine derartige Blockierschicht, insbesondere eine Exziton-Blockierschicht, bzw. Loch-Transportschicht bieten sich beispielsweise eines oder mehrere der folgenden Materialien an: N,N'-di-1-naphthyl-N,N'-diphenyl-1,1'-biphenyl-4,4'diamin (NPD), N,N'-Diphenyl-N,N'-bis(m-tolyl)-benzidin (TPD), N,N'-bis-(1-naphthyl)-N,N' diphenyl-1,1' biphenyl-4-4' diamin (NPB), 4,4',4"-Tris(N-3-methylphenyl-N-phenyl-amino)-triphenylamine (MTDATA), ein Diphenylbenzimidazolcarben-Iridium-Komplex (Ir(DPBIC)₃), Spiro-MeOTAD; ein Benzidin-Derivat, insbesondere α-NPD. Auch andere Materialien können grundsätzlich eingesetzt werden. Da diese Materialien teilweise transparent sind, können sie auch als "optische Abstandshalter" zwischen der Solarzelle und der Top-Elektrode verwendet werden.

### Zweite Elektrode

Als zweite Elektrode, die insbesondere als Top-Elektrode ausgestaltet sein kann (siehe das oben beschriebene Beispiel eines bevorzugten Aufbaus), lassen sich ebenfalls mehrere aus dem Stand der Technik bekannte Konzepte einsetzen. Beispiele derartiger Top-Elektroden sind in WO 02/101838 (insbesondere S. 18-20) aufgeführt.

So lassen sich insbesondere Metallelektroden verwenden, welche ein oder mehrere Metalle in reiner Form oder als Mischung/Legierung aufweisen können, wie insbesondere Aluminium oder Silber. Auch die Verwendung von anorganisch/organischen Mischelektroden oder Mehrschichtelektroden ist möglich, wie beispielsweise die Verwendung von LiF/AI-Elektroden.

Weiterhin lassen sich auch Elektrodenkonzepte einsetzen, bei denen die Quanteneffizienz der Bauelemente dadurch erhöht wird, dass die Photonen durch entsprechende Reflexionen gezwungen werden, die absorbierenden Schichten mindestens zweimal zu durchlaufen. Derartige Schichtaufbauten werden auch als "Konzentratoren" bezeichnet und sind ebenfalls beispielsweise in WO 02/101838 (insbesondere S. 23-24) beschrieben.

Neben der beschriebenen Tandemsolarzelle in einer der dargestellten Ausführungsformen wird auch ein Verfahren zur Herstellung eines photovoltaischen Elements vorgeschlagen. Dieses Verfahren kann insbesondere zur Herstellung eines photovoltaischen Elements in einer der oben beschriebenen Ausführungsformen eingesetzt werden. So lassen sich insbesondere die oben vorgeschlagenen Materialien und Schichten und besondere Ausgestaltungen des photovoltaischen Elements gemäß den Unteransprüchen der Erfindung in entsprechende optionale und bevorzugte Verfahrensschritte umwandeln, welche erfindungsgemäß als besondere Ausführungsformen des vorgeschlagenen Verfahrens eingesetzt werden können. Es sei jedoch darauf hingewiesen, dass sich erfindungsgemäße photovoltaische Elemente auch nach anderen Verfahren als dem vorgeschlagenen Herstellungsverfahren erzeugen lassen, so dass aus dem Herstellungsverfahren in der Regel keine Einschränkungen hinsichtlich der Ausgestaltung des vorgeschlagenen photovoltaischen Elements ableitbar sind.

Das erfindungsgemäße Verfahren weist folgende Schritte auf, welche jedoch nicht notwendigerweise in der dargestellten Reihenfolge durchgeführt werden müssen. Weiterhin können auch zusätzliche Verfahrensschritte durchgeführt werden, beispielsweise Verfahrensschritte zur Erzeugung der oben beschriebenen bevorzugten besonderen Ausgestaltungen des photovoltaischen Elements. Auch können einzelne oder mehrere Verfahrensschritte zeitlich parallel oder zeitlich überlappend durchgeführt werden und/oder können wiederholt durchgeführt werden.

Die Verfahrensschritte des vorgeschlagenen Verfahrens sind:
- eine Farbstoffsolarzelle wird hergestellt, wobei folgende Schritte durchgeführt werden:
   o mindestens ein n-halbleitendes Metalloxid wird auf eine erste Elektrode (118) aufgebracht;
   o mindestens ein in einem ersten Spektralbereich elektromagnetische Strahlung absorbierender Farbstoff wird auf das n-halbleitende Metalloxid aufgebracht;
   o mindestens ein fester p-Halbleiter wird auf das n-halbleitende Metalloxid aufgebracht;
- eine organische Solarzelle wird hergestellt, wobei die organische Solarzelle ausgestaltet ist, um elektromagnetische Strahlung in einem zweiten Spektralbereich zu absorbieren, welcher von dem ersten Spektralbereich zumindest teilweise verschieden ist, wobei folgende Schritte durchgeführt werden:
   o mindestens ein Akzeptormaterial wird auf die Farbstoffsolarzelle aufgebracht;
   o mindestens ein Donatormaterial wird auf die Farbstoffsolarzelle aufgebracht,
   o auf einer der Farbstoffsolarzelle gegenüberliegenden Seite wird mindestens eine zweite Elektrode aufgebracht, wobei die erste Elektrode und/oder die zweite Elektrode für die elektromagnetische Strahlung zumindest teilweise transparent ist.

Wie oben beschrieben, können dabei auch einzelne Verfahrensschritte ganz oder teilweise zusammengefasst werden. Beispielsweise können bei der Erzeugung der Farbstoffsolarzelle, wie oben dargestellt, die Herstellungsschritte der der Aufbringung des Farbstoffs und die Aufbringung des p-Halbleiters auch zusammengefasst werden, wie beispielsweise durch Verwendung eines entsprechenden absorbierenden Farbstoffs oder eines Pigments.

Weitere Einzelheiten und Merkmale der Erfindung ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Erfindung ist nicht auf die Ausführungsbeispiele beschränkt.

Die Ausführungsbeispiele sind in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente.

Im Einzelnen zeigt:
- Figur 1: einen Aufbau eines ersten Ausführungsbeispiels einer erfindungsgemäßen Tandem-Solarzelle;
- Figur 2: ein vereinfachtes Niveaudiagramm der in Figur 1 dargestellten Tandem- Solarzelle;
- Figuren 3A bis 3E: verschiedene Beispiele für Materialkombinationen für die in Figur 1 darge- stellte Tandem-Solarzelle;
- Figur 4: eine Strom-Spannungskennlinie eines Ausführungsbeispiels einer erfin- dungsgemäßen Tandem-Solarzelle mit einem Aufbau gemäß Figur 3A;
- Figur 5: einen Aufbau eines zweiten Ausführungsbeispiels einer erfindungsgemä- ßen Tandem-Solarzelle; und
- Figur 6: eine Strom-Spannungskennlinie des Ausführungsbeispiels gemäß Figur 5.

### Ausführunqsbeisoiel 1 :

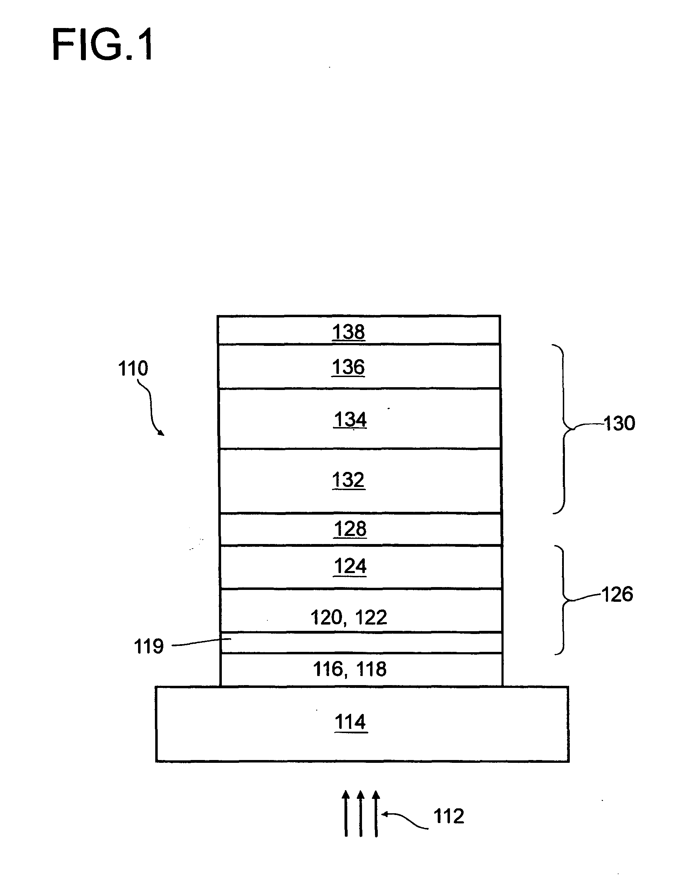

In Figur 1 ist ein erstes Ausführungsbeispiel einer Tandem-Solarzelle 110 dargestellt.
Die Tandem-Solarzelle 110 weist einen für Licht 112 (vorzugsweise Sonnenstrahlung) im Wesentlichen transparenten Träger 114 auf. Dieser Träger 114 kann, wie oben bereits teilweise ausgeführt, beispielsweise ein Glassubstrat, ein transparentes Kunststoffsubstrat (beispielsweise eine Polyethylen-Folie, eine PET-Folie, eine PTFE-Folie oder andere Arten von Kunststoffen) oder Laminate derartiger oder anderer Materialien umfassen. Es sei darauf hingewiesen, dass bei andersartigen Aufbauten als dem in Figur 1 dargestellten beispielhaften Aufbau, beispielsweise einem Aufbau, bei welchem die Sonneneinstrahlung in Figur 1 von oben erfolgt, kein transparenter Träger 114 erforderlich sein könnte, so dass hierfür auch auf andere Arten von Trägern zurückgegriffen werden könnte. Bei dem in Figur 1 dargestellten Beispiel ist die Transparenz des Trägers 114 jedoch erforderlich.

Auf den Träger 114 ist in diesem Ausführungsbeispiel ein transparentes leitfähiges Oxid (TCO) 116 aufgebracht. Im Folgenden sei angenommen, dass es sich bei diesem TCO 116 bei diesem Ausführungsbeispiel um FTO (Fluor-dotiertes Zinnoxid) handelt. Dieses TCO 116 bildet in dem in Figur 1 dargestellten Ausführungsbeispiel somit die erste Elektrode 118 der Tandem-Solarzelle 110. Um die Tandem-Solarzelle 110 zu nutzen, kann diese erste Elektrode 118 beispielsweise über entsprechende Elektrodenkontakte (in Figur 1 nicht dargestellt) kontaktiert werden.

Auf die erste Elektrode 118 ist zunächst optional eine Pufferschicht 119 aufgebracht, welche zumindest weitgehend verhindert, dass Löcher zur ersten Elektrode 118 gelangen können. Im Folgenden sei angenommen, dass hier als Pufferschicht 119 eine einzelne Schicht eines (vorzugsweise nicht nanoporösen) Titandioxids verwendet wird. Diese Pufferschicht hat vorzugsweise eine Dicke, welche (in diesem oder auch in anderen Ausführungsbeispielen der vorliegenden Erfindung) zwischen 10 nm und 500 nm liegen kann. Derartige Schichten lassen sich beispielsweise durch Sputtern und/oder Spraypyrolyse erzeugen.

Auf die Pufferschicht 119 ist ein n-halbleitendes Metalloxid 120 aufgebracht, welches gemäß der obigen Beschreibung mit einem Farbstoff 122 sensibilisiert ist. Im Folgenden sei angenommen, dass es sich bei diesem n-halbleitenden Metalloxid 120 um Titandioxid handelt, ohne hierdurch den Umfang der Erfindung zu beschränken.

Auf das mit dem Farbstoff 122 sensibilisierte n-halbleitende Metalloxid 120 ist ein fester p-Halbleiter 124 aufgebracht. Für Möglichkeiten der Ausgestaltung und der Materialwahl für diesen p-Halbleiter 124 sei auf die nachfolgenden Beispiele verwiesen.

Das n-halbleitende Metalloxid 120 mit seiner Sensibilisierung durch den Farbstoff 122 und die Schicht des p-Halbleiters 124 bilden gemeinsam eine Farbstoffsolarzelle 126, welche hier als untere Teilzelle der Tandem-Solarzelle 110 fungiert.

An diese Farbstoffsolarzelle 126 schließt sich in das mit Figur 1 dargestellte bevorzugte Ausführungsbeispiel eine Ladungsrekombinationszone 128 an. Diese Ladungsrekombinationszone 128 kann beispielsweise als Floating-Elektrode (d.h. elektrisch nicht kontaktierte Elektrode) ausgestaltet sein und stellt in dieser Betrachtung die Top-Elektrode für die Farbstoffsolarzelle 126 und gleichzeitig die Bottom-Elektrode für eine sich anschließende organische Solarzelle 130 (siehe Beschreibung unten) dar. Diese Betrachtungsweise verdeutlicht besonders, dass es sich bei dem in Figur 1 gezeigten bevorzugten Ausführungsbeispiel um eine Zwei-Kontakt-Tandemsolarzelle handelt.

Aufbauend auf diese Ladungsrekombinationszone 128, welche, wie oben beschrieben, auch in Form einer Defektzone in einer der angrenzenden Schichten realisiert werden kann, beispielsweise in Form einer Defektzone innerhalb der obersten Schicht des p-Halbleiters 124, schließt sich bei dem in Figur 1 dargestellten Ausführungsbeispiel eine organische Solarzelle 130 an. Diese organische Solarzelle 130 bildet die zweite Teilzelle der Tandem-Solarzelle 110 und absorbiert vorzugsweise in einem längerwelligen Wellenlängenbereich das Licht 112. Vorzugsweise ist der Absorptionsbereich komplementär zum Absorptionsbereich der Farbstoffsolarzelle 126 gewählt.

Die organische Solarzelle 130 umfasst zunächst ein Akzeptormaterial 132 als n-halbleitende Schicht. An dieses Akzeptormaterial 132 schließt sich ein Donatormaterial 134 an, als p-halbleitende Schicht. Mindestens eine der Schichten 132 oder 134 muss in dem in Figur 1 dargestellten Ausführungsbeispiel absorbierende Eigenschaften für das Licht 112 aufweisen. Entsprechend kann von einem "n-Absorber" 132 bzw. einem "p-Absorber" 134 gesprochen werden. In dem in Figur 1 gezeigten Aufbau sind das Akzeptormaterial 132 und das Donatormaterial 134 als getrennte Schichten gezeigt. Wie oben erwähnt, stellt dies jedoch lediglich eine Möglichkeit dar, die organische Solarzelle 130 zu realisieren. So sind auch Mischschichten mit Akzeptor- und Donatormaterialien möglich, beispielsweise im Rahmen eines Einschichter und/oder im Rahmen einer Akzeptormaterialschicht, einer Donatormaterialschicht und einer dazwischenliegenden Mischschicht (also ein n - Bulk-Heterojunction - p-Schichtaufbau), oder es lassen sich auch vollständige Bulk Heterojunctions realisieren, also Aufbauten, bei welchen Akzeptormaterial 132 und Donatormaterial 134 entlang einer stark unebenen Grenzfläche innerhalb eines weiten Grenzbereichs (welcher bis zu einigen Mikrometern betragen kann) ineinandergreifen. Weiterhin lassen sich, alternativ oder zusätzlich zu den genannten Möglichkeiten, auch jeweils mehrere Akzeptormaterialien 132 und/oder mehrere Donatormaterialien 134 einsetzen, welche wiederum beispielsweise als getrennte Schichten und/oder auch als Mischschichten verwendet werden können. Alle Schichten und Materialien können, wie auch sonst üblich, sowohl in reiner, undotierter Form als auch in dotierter Form eingesetzt werden.

An das Donatormaterial 134 schließt sich in dem in Figur 1 dargestellten Ausführungsbeispiel eine (optionale) Blockierschicht 136 an. Auf diese Blockierschicht 136 ist eine zweite Elektrode 138 als Top-Kontakt aufgebracht, welche als zweite Elektrode der hier realisierten Zwei-Kontakt-Tandem-Solarzelle 110 fungieren kann. Entsprechend kann diese zweite Elektrode 138 durch entsprechende Elektrodenkontakte kontaktiert werden, so dass zwischen der ersten Elektrode 118 und der zweiten Elektrode 138 die Photospannung abgegriffen werden kann. Die Blockierschicht 136 dient bei dem in Figur 1 dargestellten Ausführungsbeispiel insbesondere dazu, zu verhindern, dass Material der zweiten Elektrode 138 in die Schicht des Donatormaterials 134 eindringen kann.

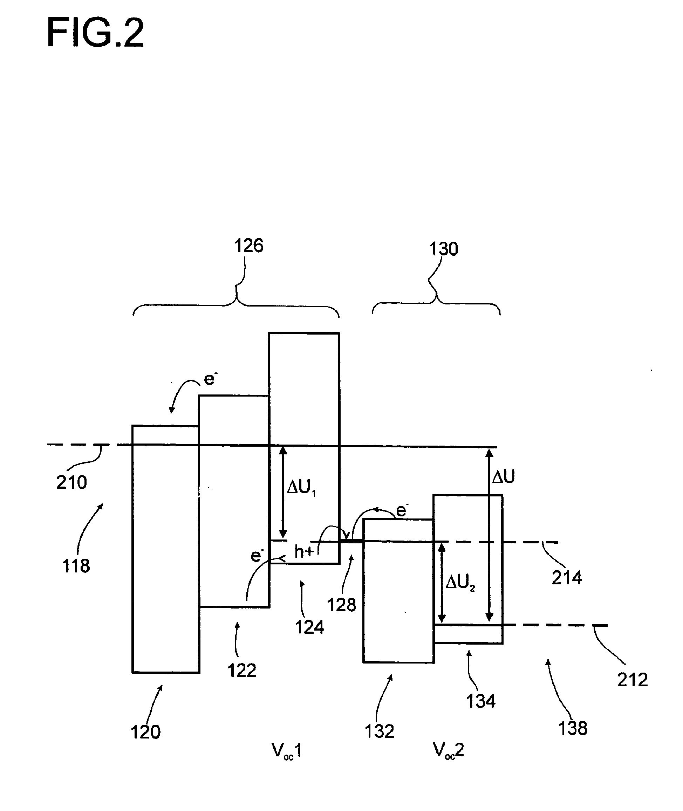

In Figur 2 ist ein Niveaudiagramm des in Figur 1 dargestellten Schichtaufbaus der Tandem-Solarzelle 110 dargestellt. Dabei wurde aus Gründen der Vereinfachung die Blockierschicht 136, welche im Idealfall keine wesentliche elektrische Funktion übernimmt, weggelassen.

Die erste Elektrode 118 und die zweite Elektrode 138 sind dabei bei dem in Figur 2 gezeigten Aufbau jeweils durch ihr Fermi-Niveau 210 bzw. 212 gekennzeichnet. Das Niveau der nicht-kontaktierten Ladungsrekombinationszone, welche beispielsweise eine Floating-Metallelektrode umfassen kann und welches dementsprechend näherungsweise dem Vakuumniveau entspricht, ist in Figur 2 mit 214 bezeichnet.

Weiter sind in Figur 2 jeweils die einzelnen Niveaus der Schichten der Farbstoffsolarzelle 126 und der organischen Solarzelle 130 symbolisch eingezeichnet. Dabei bezeichnet jeweils die untere waagerechte Kante eines Rechtecks das Niveau des Valenzbandes der entsprechenden Schicht (sofern es sich um einen anorganischen Halbleiter handelt), bzw. im Molekülorbital-Modell das Niveau des höchsten besetzten Molekülorbitals (HOMO). Die oberen waagerechten Kanten jedes Rechtecks bezeichnen die energetische Lage des Leitungsbandes bzw. (im Molekülorbital-Modell) das Niveau des niedrigsten unbesetzten Molekülorbitals (LUMO).

Aus dem in Figur 2 dargestellten Niveaudiagramm lässt sich die oben bereits beschriebene Funktionsweise der Tandem-Solarzelle 110 erkennen. So werden im Farbstoff 122 Photonen des Lichts 112 einer ersten Wellenlänge absorbiert, wodurch im Farbstoff 122 angeregte Molekülzustände entstehen. Diese geben ein Elektron in das Leitungsband des n-halbleitenden Metalloxids 120 ab, von wo aus diese zur ersten Elektrode 118 abfließen können.

Zum Ladungsausgleich des Farbstoffs 122 überträgt das p-Halbleiter-Material 124 Elektronen an den Farbstoff 122, wodurch im p-Halbleiter 124 Löcher entstehen. Diese wiederum werden an der Ladungsrekombinationszone 128 ausgeglichen. Durch den Transport von Löchern (h⁺) und Elektronen (e⁻) entsteht zwischen der Ladungsrekombinationszone 128 und der ersten Elektrode 118 eine Potentialdifferenz ΔU₁, welche einer Photospannung V_{oc}1 der Farbstoffsolarzelle 126 entspricht. Würde der Solarzellenaufbau lediglich die Farbstoffsolarzelle 126 umfassen, so wäre dies die an den Elektrodenkontakten abgreifbare Spannung.

Weiterhin umfasst die Tandem-Solarzelle 110 jedoch, wie oben beschrieben, die organische Solarzelle 130. In dieser organischen Solarzelle 130 werden Photonen einer zweiten, längeren Wellenlänge des Lichts 112 absorbiert. Die Wellenlänge des absorbierten Lichts hängt von den Eigenschaften des Akzeptormaterial 132 und/oder des Donatormaterials 134 ab, insbesondere deren Bandlücke. Auf diese Weise entstehen im Akzeptormaterial 132 und/oder im Donatormaterial 134 Exzitonen, welche am Übergang zwischen den Materialien 132, 134 in Elektronen und Löcher zerfallen. Die Elektronen wandern zur Ladungsrekombinationszone 128, die Löcher zur zweiten Elektrode 138. Somit entsteht zwischen der zweiten Elektrode 138 und der Ladungsrekombinationszone 128 eine Potentialdifferenz ΔU₂, welche einer Photospannung V_{oc}2 entspricht. Diese Photospannung V_{oc}2 wäre diejenige Photospannung, die an den offenen Elektrodenkontakten der Solarzelle abgegriffen würde, wenn diese lediglich die organische Solarzelle 130 umfassen würde.

Insgesamt ergibt sich die gesamte Photospannung der Tandem-Solarzelle 110, solange die Elektroden 118 und 138 getrennt sind und kein Strom durch die Tandem-Solarzelle 110 fließt, somit als Summe der beiden Photospannungen V_{oc}1 und V_{oc}2.

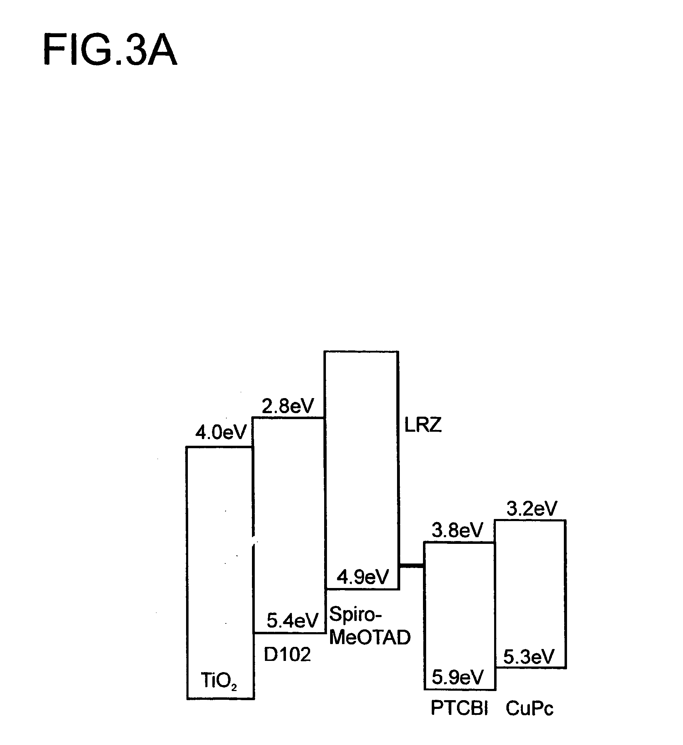

Um das neuen Tandemzellen-Konzept zu testen, wurden wie folgt Tandem-Solarzellen 110 mit einem analog zu den Figuren 1 und 2 ausgestalteten Schichtaufbau hergestellt. Der Schichtaufbau ist in Figur 3A dargestellt.

Als Basismaterial wurden mit fluordotiertem Zinnoxid (FTO) beschichtete Glasplatten der Abmessung 25 mm x 15 mm x 3 mm (Nippon Sheet Glass) eingesetzt, die nacheinander mit Glasreiniger (RBS 35), voll entsalztem Wasser und Aceton jeweils 5 min im Ultraschallbad behandelt, dann 10 Minuten in Iso-Propanol gekocht und im Stickstoffstrom getrocknet wurden.

Zur Herstellung der festen TiO₂-Pufferschicht 119 wurde ein Sputterverfahren eingesetzt. Alternativ oder zusätzlich lassen sich jedoch auch andere Verfahren, wie beispielsweise Spraypyrolyseverfahren, einsetzen. Darauf wurde eine TiO₂-Paste (Hersteller Catalysts & Chemicals IND. CO., LTD (CCl)), die TiO₂-Partikel mit einem Durchmesser von 25 nm in einer Terpineol/Ethylzellulose-Dispersion enthält, mit einem Spincoater bei 4500 U/min aufgeschleudert und 30 min bei 90°C getrocknet. Nach einem 45-minütigem Aufheizen auf 450°C und einem 30-minütigem Sinterschritt bei 450°C ergab sich eine TiO₂-Schichtdicke von näherungsweise 0.5 µm, was jedoch nicht durch eine Messung bestätigt wurde.

Zur elektrischen Abisolation der Metallrückelektroden von der Arbeitselektrode wurden auf die TiO₂-Schich an den Rändern längsseitig jeweils ein Streifen Polyimid (Pyrolin Polyimide Coating, Hersteller Supelco) aufgetragen und für 15 min bei 200°C im Trockenschrank ausgehärtet.

Nach Herausnehmen aus dem Trockenschrank wurde die Probe auf 80°C abgekühlt und 12 h in eine 5 x 10⁻⁴ mM Lösung eines Farbstoffs in MeCN/t-BuOH 1:1 getaucht. Als Farbstoff wurde dabei der Farbstoff D102 verwendet, wie er in Schmidt-Mende et al., Adv. Mater. 2005, 17, 813 beschrieben ist. Nach Herausnehmen aus der Lösung wurde die Probe anschließend mit dem gleichen Lösungsmittel abgespült und im Stickstoffstrom getrocknet. Die derart erzeugten Proben wurden anschließend bei 40°C im Vakuum getrocknet.

Als nächstes wurde eine p-Halbleiter-Lösung aufgeschleudert. Dazu wurde eine 0.16 M Spiro-MeOTAD (Merck, SHT-263), 15 mM LiN(SO₂CF₃)₂ (Aldrich), 0.12M 4-t-Butylpyridin (Aldrich)-Lösung in Chlorbenzol angesetzt. 150 µl dieser Lösung wurde auf die Probe aufgebracht und 60 s einwirken lassen. Danach wurde die überstehende Lösung 30 s bei 2000 Umdrehungen pro Minute abgeschleudert und 4 h bei 40°C im Vakuumofen getrocknet.

Im Anschluss daran wurde eine dünne Ladungsrekombinationszone aufgebracht. Dazu wurde Ag durch thermische Metallverdampfung im Vakuum mit einer Rate von 0.1 nm/s bei einem Druck von 5*10⁻⁵ mbar verdampft, so dass eine etwa 1 nm dicke Ag-Schicht entstand. Eine derartige Schicht wies noch gute Transparenzeigenschaften im sichtbaren Spektralbereich auf.

Darauf wurden weitere aktive organische Schichten in der folgenden Reihenfolge aufgedampft. Zuerst wurde als Akzeptormaterial Perylen-tetracarbonsäure-bisbenzimidazol (PTCBI, zweifach gradientensublimiert) als Isomerengemisch, und dann als Donatormaterial Kupferphthalocyanin (CuPc, einfach gradientensublimiert) aufgebracht. Eine Blockierschicht 136 wurde in diesem Ausführungsbeispiel nicht verwendet, ist jedoch optional möglich. Es wurde bei einem Druck von 8*10⁻⁶ mbar gearbeitet. Die Verdampfung des PTCBI fand bei einer Temperatur von 440°C und einer Aufdampfrate von 0.2-1.0 nm/s statt, CuPc wurde bei 380°C mit einer Rate von 0.2-1.0 nm/s aufgedampft. Die entstandenen Schichtdicken betrugen 50 nm für die PTCBI-Schicht und ebenfalls 50 nm für die CuPc-Schicht.

Die Metallrückelektrode (zweite Elektrode) wurde durch thermische Metallverdampfung im Vakuum aufgebracht. Dazu wurde die Probe mit einer Maske versehen, um 4 voneinander getrennte rechteckige Rückelektroden mit Abmessungen von ca. 4 mm x 3 mm auf die aktive Region zu bedampfen, die jeweils mit einer etwa 3 mm x 2 mm großen Kontaktfläche über der oben beschriebenen Polyimidschicht verbunden sind. Als Metall wurde Au verwendet, das mit einer Rate von 0.2-1.0 nm/s bei einem Druck von ca. 5*10⁻⁵ mbar verdampft wurde, so dass eine Schichtdicke von etwa 50 nm entstand.

Zur Bestimmung des Wirkungsgrads η wurde die jeweilige Strom/Spannungs-Kennlinie mit einem Source Meter Model 2400 (Keithley Instruments Inc.) unter Bestrahlung mit einem Halogen-Lampenfeld (Xenophot® 64629; Osram) als Sonnensimulator gemessen.

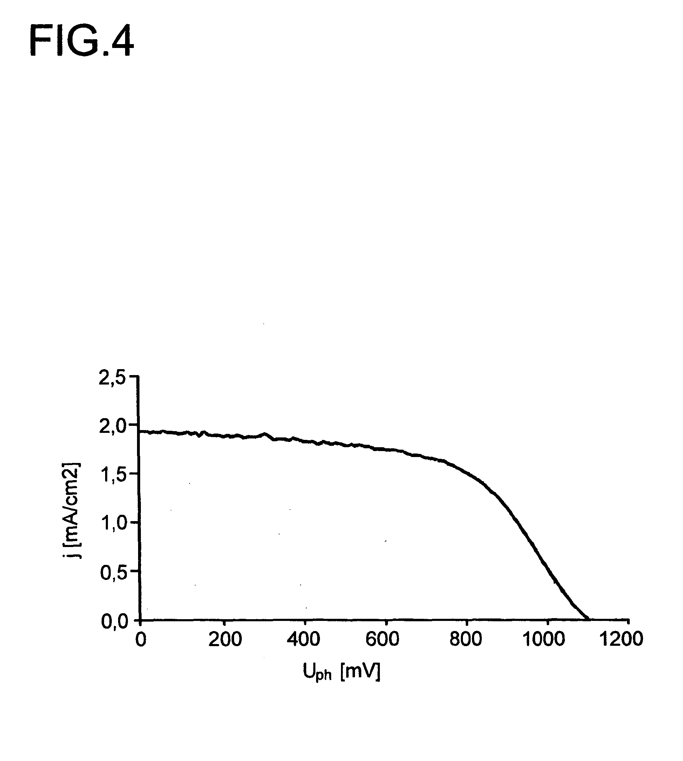

Es ergab sich eine Strom/Spannungs-Kennlinie bei einer Beleuchtungsstärke von 100mW/cm², welche in Figur 4 gezeigt ist. Dabei ist auf der Abszisse die Photospannung Uₚₕ in mV aufgetragen, so dass sich nach rechts auf dieser Achse die Last an der Tandem-Solarzelle 110 erhöht. Auf der Ordinate ist die gemessene Stromdichte j in mA/cm² aufgetragen.

Der Kurzschluss-Strom (also die Stromdichte bei Lastwiderstand Null) betrug 1,93 mA/cm², die offene-Klemmen-Spannung V_{oc} (also die Last, bei welcher die Stromdichte auf Null abgesunken ist) betrug 1103 mV, der Füllfaktor betrug 57%, und der Wirkungsgrad lag bei 1,2%.

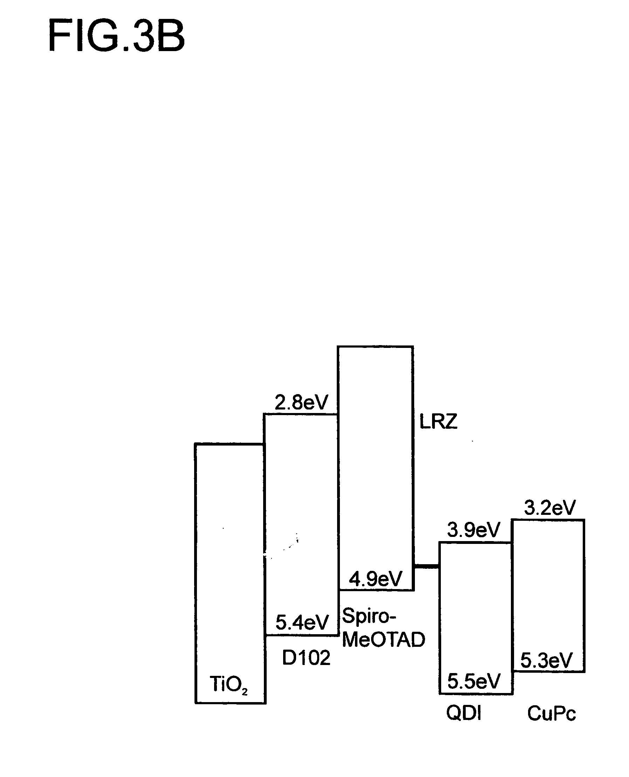

In den Figuren 3B bis 3E sind zu Figur 3A alternative Ausführungsbeispiele schematisch dargestellt. Dabei ist bei dem in Figur 3B dargestellten Aufbau das PTCBI des Akzeptormaterials 132 durch das Material QDI ersetzt. Das Akzeptormaterial QDI (Quaterrylendümid) ist beispielsweise aus K. Müllen et al., Chem.Mater. 18, 3715-3725 (2006) bekannt (dort als "Verbindung 3" bezeichnet).

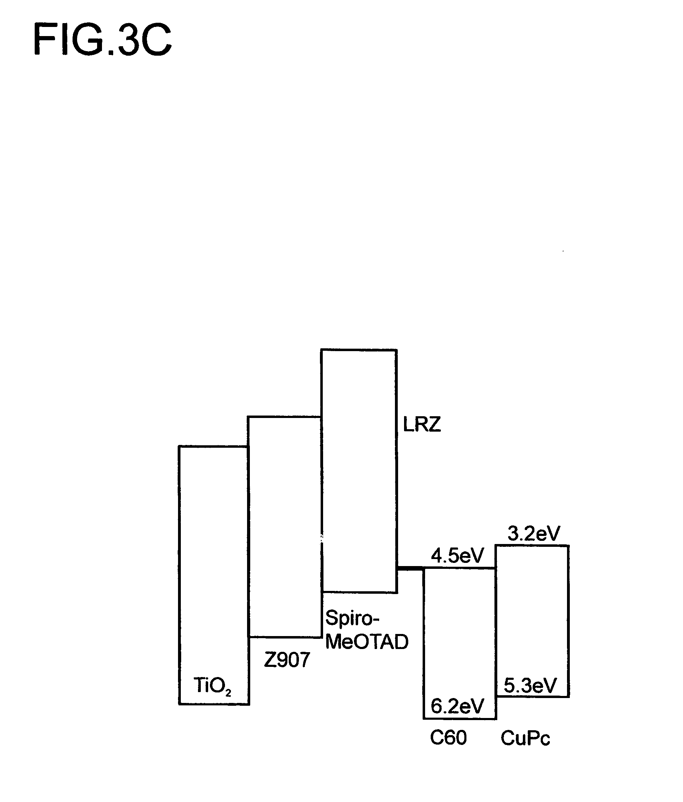

In Figur 3C ist gegenüber dem Aufbau in Figur 3B der Farbstoff D102 durch den Farbstoff Z907 als Farbstoff 122 ersetzt (siehe hierzu M. Grätzel et al., Appl. Phys. Lett. 86, 013504 (2005)). Weiterhin ist das QTCBI bzw. QDI als Akzeptormaterial 132 durch das Fulleren C60 ersetzt.

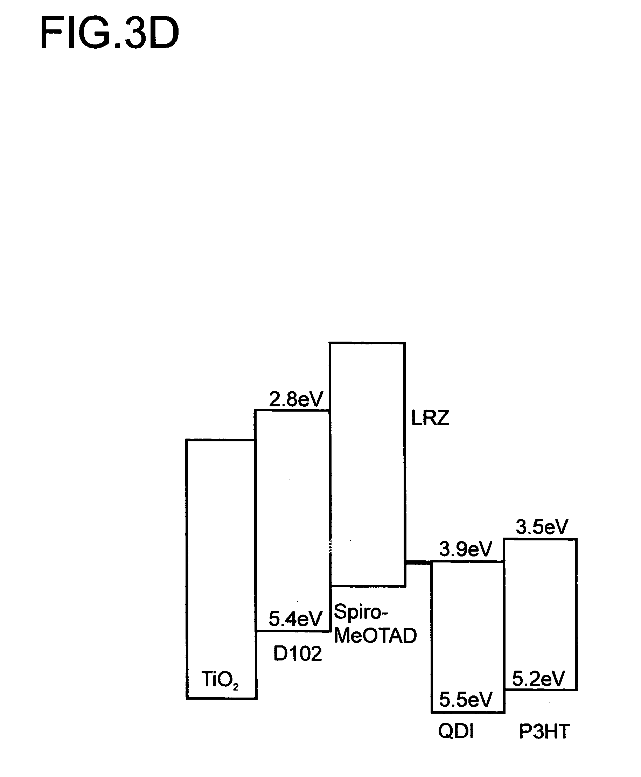

Figur 3D stellt wiederum eine Abwandlung des Schichtaufbaus in Figur 3B dar. Dabei ist gegenüber dem Aufbau in Figur 3B CuPc als Donatormaterial 134 durch P3HT ersetzt.

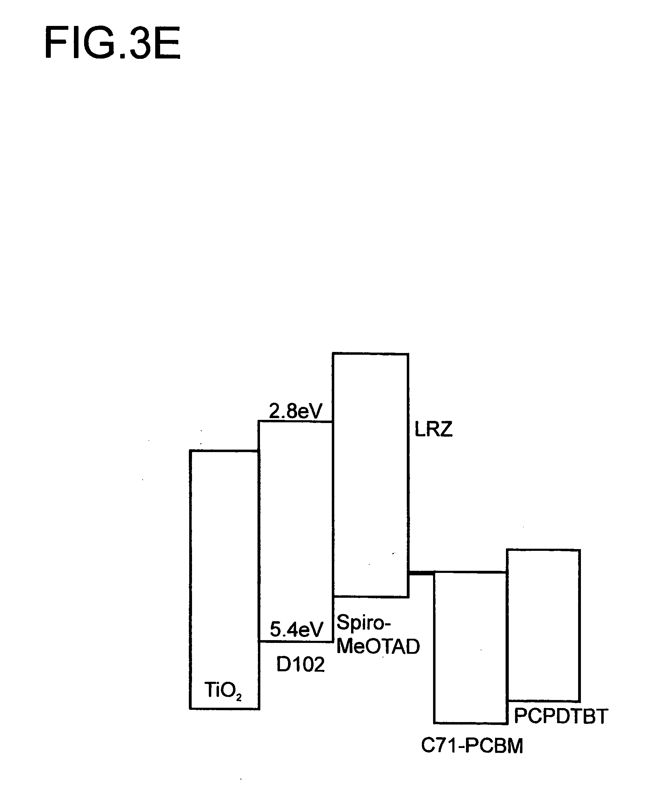

Figur 3E entspricht dem Aufbau in Figur 3D, wobei jedoch das QDI als Akzeptormaterial 132 durch C71-PCBM und das P3HT als Donatormaterial 134 durch PCPDTBT ersetzt ist.

In allen Fällen sind jeweils für Tandem-Solarzelle 110 die HOMO und LUMO-Niveaus in Elektronenvolt (eV) eingezeichnet, soweit diese bekannte sind. Die Ladungsrekombinationszone 128 ist in den Figuren 3A bis 3E mit LRZ bezeichnet.

### Ausführungsbeispiel 2:

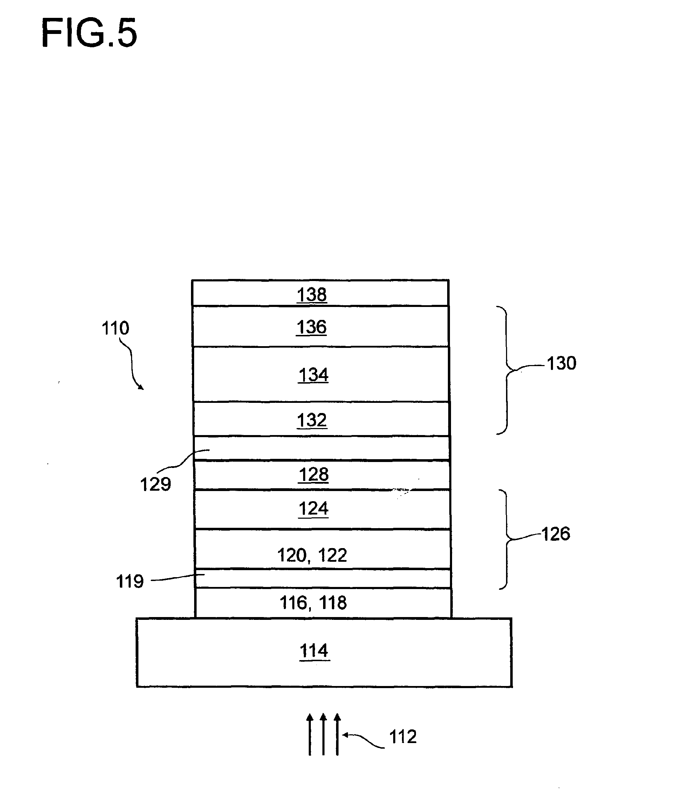

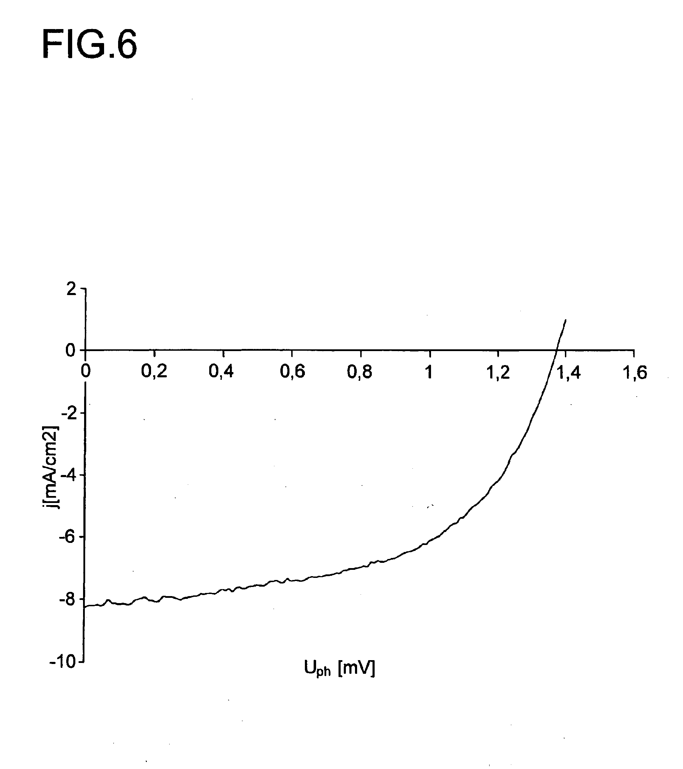

In den Figuren 5 und 6 ist ein weiteres Ausführungsbeispiel einer erfindungsgemäßen Tandem-Solarzelle 110 dargestellt. Dabei zeigt Figur 5 eine zu Figur 1 analoge schematische Darstellung des Schichtaufbaus. In Figur 6 sind Messdaten dieses Aufbaus dargestellt, ähnlich zu der Darstellung in Figur 4.

Der in Figur 5 gezeigte Schichtaufbau entspricht zunächst weitgehend dem Schichtaufbau gemäß Figur 1, so dass für die Funktion der dargestellten Schichten weitgehend auf die Beschreibung der Figur 1 verwiesen werden kann. Die Materialauswahl und die Herstellung der Schichtabfolge wird im Folgenden dargestellt. Ein wesentlicher Unterschied des Schichtaufbaus im Ausführungsbeispiel gemäß Figur 5 zu Figur 1 besteht darin, dass zwischen der Ladungsrekombinationszone 128 und der organischen Solarzelle 130, hier dem Akzeptormaterial 132 der organischen Solarzelle 130, eine Elektrontransportschicht 129 eingefügt ist, um eine elektrische Kopplung der Ladungsrekombinationszone 128 an die organische Solarzelle 130 zu verbessern.

Der in Figur 5 dargestellt Schichtaufbau wurde wie folgt erzeugt.

Als Basismaterial, das heißt als Träger 114 und als TCO-Schicht und erste Elektrode 118 wurden mit fluordotiertem Zinnoxid (FTO) beschichtete Glasplatten der Abmessung 25 mm x 15 mm x 3 mm (Nippon Sheet Glass) eingesetzt, die nacheinander mit Glasreiniger (RBS 35), voll entsalztem Wasser und Aceton jeweils 5 min im Ultraschallbad behandelt, dann 10 Minuten in Iso-Propanol gekocht und im Stickstoffstrom getrocknet wurden.

Analog zu Figur 1 wurde wiederum auch eine optionale Pufferschicht 119 in Form einer festen TiO₂-Pufferschicht verwendet. Zur Herstellung dieser festen TiO₂-Pufferschicht 119 wurde ein Spraypyrolyseverfahren eingesetzt.

Auf die Pufferschicht 119 wurde wiederum eine Schicht eines n-halbleitenden Metalloxids 120 aufgebracht. Zu diesem Zweck wurde eine TiO₂-Paste (Dyesol, DSL 18NR-T), mit einem Spincoater bei 4500 Umdrehungen pro Minute aufgeschleudert und 30 min bei 90°C getrocknet. Nach einem 45-minütigem Aufheizen auf 450°C und einem 30-minütigem Sinterschritt bei 450°C ergab sich eine TiO₂-Schichtdicke von näherungsweise 1,8 µm.

Die derart hergestellten Zwischenprodukte wurden danach optional mit TiCl₄ behandelt, wie von Grätzel beispielsweise in Grätzel M. et al., Adv. Mater. 2006, 18, 1202 beschrieben.

Zur elektrischen Isolation später aufzubringenden zweiten Elektroden 138 (Metallrückelektroden) von der ersten Elektrode 118 (Arbeitselektrode) wurde auf die TiO₂-Schicht an den Rändern längsseitig jeweils ein Streifen Polyimid (Pyrolin Polyimide Coating, Hersteller Supelco) aufgetragen und für 15 min bei 200°C im Trockenschrank ausgehärtet.

Zum Aufbringen des Farbstoffs 122 wurde die Probe nach Herausnehmen aus dem Trockenschrank auf 80°C abgekühlt und 2 h in eine 5x10⁻⁴ mM Lösung des Farbstoffs in MeCN/t-BuOH 1:1 getaucht. Als Farbstoff 122 wurde dabei der Farbstoff D102 verwendet, wie er in Schmidt-Mende et al., Adv. Mater. 2005, 17, 813 beschrieben ist. Nach Herausnehmen aus der Lösung wurde die Probe anschließend mit dem gleichen Lösungsmittel abgespült und im Stickstoffstrom getrocknet. Die derart erzeugten Proben wurden anschließend bei 40°C im Vakuum getrocknet.

Zur Erzeugung der p-Halbleiterschicht 124 wurde als nächstes eine p-Halbleiter-Lösung aufgeschleudert. Dazu wurde eine 0.12 M Spiro-MeOTAD (Merck, SHT-263), 15 mM LiN(SO₂CF₃)₂ (Aldrich), 0.06M 4-t-Butylpyridin (Aldrich)-Lösung in Chlorbenzol angesetzt. 75 µl dieser Lösung wurde auf die Probe aufgebracht und 60 s einwirken lassen. Danach wurde die überstehende Lösung 30 s bei 2000 Umdrehungen pro Minute abgeschleudert und über Nacht im Dunkeln gelagert.

Im Anschluss daran wurde, wie auch schon im Ausführungsbeispiel gemäß Figur 1, eine dünne Ladungsrekombinationszone 128 aufgebracht. Dazu wurde Ag durch thermische Metallverdampfung im Vakuum mit einer Rate von 0.1 A/s bei einem Druck von 3*10⁻⁶ mbar verdampft, so dass eine etwa 2 nm dicke Ag-Schicht entstand. Eine derartige Schicht wies noch gute Transparenzeigenschaften im sichtbaren Spektralbereich auf.

Darauf wurden weitere aktive organische Schichten in der folgenden Reihenfolge aufgedampft. So wurde, wie oben dargestellt, bei dem Ausführungsbeispiel gemäß Figur 5 zwischen die Ladungsrekombinationszone 128 und die organische Solarzelle 130 eine Elektrontransportschicht 129 eingefügt. Zu diesem Zweck wurde zunächst auf die als Ladungsrekombinationszone 128 dienende Silberschicht eine Bphen-Schicht als Elektrontransportschicht 129 mit einer Schichtdicke von 5 nm bei einer Rate von 0.7A/s und einer Temperatur von 140°C aufgedampft. Diese Schicht wirkt als Excitionblocker für die nachfolgende C₆₀-Schicht des Akzeptormaterials 132 und stellt einen guten elektronischen Kontakt zwischen den Fullerenen und der Ladungsrekombinationszone 128 sicher.

Auf die Bphen-Schicht der Elektrontransportschicht 129 folgte eine als Akzeptormaterial 132 und Elektronenleiter dienende C₆₀-Schicht mit einer Schichtdicke von 20 nm. Diese wurde mit einer Rate von 2 A/s und einer Temperatur von 400°C aufgedampft.

Es folgte als Donatormaterial 134 eine 40 nm dicke Schicht aus koverdampftem Zinkphthalocyanin (ZnPc, zweifach gradientensublimiert), das als eigentliches Donatormaterial (Matrix) diente, und dem Akzeptor C₆₀. ZnPc wurde bei 380°C verdampft. Die Aufdampfrate beider Materialien lag bei 1 A/s. Diese koverdampfte Schicht stellt eine effiziente Umwandlung der Excitonen am Übergang zwischen dem Akzeptormaterial 132 und dem Donatormaterial 134 in Ladungsträger sicher. Es wurde bei einem Druck von 2*10⁻⁶ mbar gearbeitet.

Als zweite Elektrode 138 wurde eine Metallrückelektrode durch thermische Metallverdampfung im Vakuum aufgebracht. Als Metall wurde Ag verwendet, das mit einer Rate von 3 A/s bei einem Druck von ca. 2*10⁻⁶ mbar verdampft wurde, so dass eine Schichtdicke von etwa 100 nm entstand.

Die derart erzeugte Tandem-Solarzelle 110 wurde anschließend auf ihre elektrischoptischen Eigenschaften vermessen. Dies ist anhand der Kennlinie in Figur 6 verdeutlicht, in welcher, analog zu Figur 4, wiederum die Stromdichte j gegen die Photospannung Uₚₕ aufgetragen ist. Die Auftragung erfolgte hier mit anderem Vorzeichen als in Figur 4, was jedoch messtechnisch und nicht durch grundlegende physikalische Unterschiede bedingt ist.

Zur Bestimmung des Wirkungsgrads η wurde die jeweilige Strom/Spannungs-Kennlinie mit einem Source Meter Model 2400 (Keithley Instruments Inc.) unter Bestrahlung mit einem Halogen-Lampenfeld (Xenophot® 64629; Osram) als Sonnensimulator gemessen.

Der Kurzschluss-Strom (also die Stromdichte bei Lastwiderstand Null) betrug 8,25 mA/cm², die offene-Klemmen-Spannung V_{oc} (also die Last, bei welcher die Stromdichte auf Null abgesunken ist) betrug 1370 mV, der Füllfaktor betrug 54%, und der Wirkungsgrad lag bei 6,14%. Diese Messergebnisse zeigen, dass der erfindungsgemäße Aufbau zu photovoltaischen Elementen mit hohem Wirkungsgrad führt.

### Bezugszeichenliste

- 110: Tandem-Solarzelle
- 112: Licht
- 114: Träger
- 116: transparentes leitfähiges Oxid, TCO
- 118: erste Elektrode
- 119: Pufferschicht
- 120: n-halbleitendes Metalloxid
- 122: Farbstoff
- 124: p-Halbleiter
- 126: Farbstoffsolarzelle
- 128: Ladungsrekombinationszone
- 129: Elektrontransportschicht
- 130: organische Solarzelle
- 132: Akzeptormaterial
- 134: Donatormaterial
- 136: Blockierschicht
- 138: zweite Elektrode, Top-Kontakt
- 210: Fermi-Niveau erste Elektrode
- 212: Fermi-Niveau zweite Elektrode
- 214: Vakuumniveau

## Patentansprüche

1. Photovoltaisches Element (110) zur Umwandlung elektromagnetischer Strahlung in elektrische Energie, wobei das photovoltaische Element (110) einen Tandemzellenaufbau aufweist, wobei der Tandemzellenaufbau folgendes umfasst:
- eine Farbstoffsolarzelle (126) mit einer ersten Elektrode (118), einem n-halbleitenden Metalloxid (120), einem in einem ersten Spektralbereich elektromagnetische Strahlung absorbierenden Farbstoff (122) und einem festen p-Halbleiter (124); und
- eine organische Solarzelle (130) mit einem Akzeptormaterial (132) und einem Donatormaterial (134), wobei das Akzeptormaterial (132) und/oder das Donatormaterial (134) ein organisches Material umfasst, wobei die organische Solarzelle (130) weiterhin auf einer der Farbstoffsolarzelle (126) gegenüberliegenden Seite eine zweite Elektrode (138) umfasst, wobei die organische Solarzelle ausgestaltet ist, um elektromagnetische Strahlung in einem zweiten Spektralbereich zu absorbieren, welcher von dem ersten Spektralbereich zumindest teilweise verschieden ist,
- wobei die erste Elektrode (118) und/oder die zweite Elektrode (138) für die elektromagnetische Strahlung zumindest teilweise transparent ist,
- wobei das photovoltaische Element (110) zwischen der Farbstoffsolarzelle (126) und dem organischen Akzeptormaterial (132) der organischen Solarzelle (130) mindestens eine Ladungsrekombinationszone (128) aufweist.

2. Photovoltaisches Element (110) nach dem vorhergehenden Anspruch, wobei der Tandemzellenaufbau ein Zwei-Kontakt-Tandemzellenaufbau ist, wobei das photovoltaische Element (110) einen ersten, mit der ersten Elektrode (118) elektrisch verbundenen elektrischen Kontakt und einen zweiten, mit der zweiten Elektrode (138) elektrisch verbundenen elektrischen Kontakt aufweist.

3. Photovoltaisches Element (110) nach einem der vorhergehenden Ansprüche, wobei die Ladungsrekombinationszone (128) mindestens eines der folgenden Materialien aufweist: ein Metall, insbesondere Ag, Au, Li, Al, Ti oder Sn; ein Metallhalogenid, insbesondere LiF; ein Metalloxid, insbesondere WO₃; ein dotiertes Metalloxid; einen mit Störstellen dotierten Bereich, insbesondere einen Bereich, in den eine Schichtstruktur der organischen Solarzelle (130) derart modifiziert ist, dass Defekte in die Schichtstruktur eingebracht sind; einen hochdotierten p/n-Übergang.

4. Photovoltaisches Element (110) nach einem der vorhergehenden Ansprüche, wobei die Ladungsrekombinationszone (128) eine Schichtdicke von weniger als 2,0 nm aufweist.

5. Photovoltaisches Element (110) nach einem der vorhergehenden Ansprüche, wobei zwischen der Ladungsrekombinationszone (128) und der organischen Solarzelle (130) weiterhin mindestens eine Elektrontransportschicht (129) eingebracht ist.

6. Photovoltaisches Element (110) nach einem der vorhergehenden Ansprüche, wobei die organische Solarzelle (130) einen Übergang zwischen einer Schicht des Akzeptormaterials (132) und einer Schicht des Donatormaterials (134) aufweist, wobei die Schicht des Akzeptormaterials (132) auf einer der Farbstoffsolarzelle (126) zugewandten Seite und die Schicht des Donatormaterials (134) auf einer der Farbstoffsolarzelle (126) abgewandten Seite des Übergangs angeordnet ist.

7. Photovoltaisches Element (110) nach einem der vorhergehenden Ansprüche, wobei zwischen der ersten Elektrode (118) und dem n-halbleitenden Metalloxid (120) mindestens eine Pufferschicht (119), insbesondere eine Pufferschicht (119) mit einem Puffer-Metalloxid, insbesondere einem transparenten Puffer-Metalloxid, eingebracht ist.

8. Photovoltaisches Element (110) nach einem der vorhergehenden Ansprüche, wobei die erste Elektrode (118) und/oder die zweite Elektrode (138) mindestens eines der folgenden Materialien aufweist: eine Metallfolie, insbesondere eine Aluminiumfolie oder eine Silberfolie; einen Metallfilm, insbesondere einen Aluminiumfilm oder einen Silberfilm; ein transparentes leitfähiges Oxid, insbesondere mit Fluor und/oder mit Indium dotiertes Zinnoxid oder aluminiumdotiertes Zinkoxid; Kohlenstoffnanoröhren.

9. Photovoltaisches Element (110) nach einem der vorhergehenden Ansprüche, wobei genau eine der ersten und der zweiten Elektrode (118, 138) zumindest teilweise transparent für die elektromagnetische Strahlung ist und wobei die andere der ersten und der zweiten Elektrode (118, 138) zumindest teilweise reflektierend für die elektromagnetische Strahlung ist.

10. Photovoltaisches Element (110) nach einem der vorhergehenden Ansprüche, wobei das n-halbleitende Metalloxid (120) mindestens eines der folgenden Materialien aufweist: Zinkoxid; Zinndioxid; Titandioxid; Zinn(IV)-oxid; Wolfram(VI)oxid; Tantal(V)oxid; Niob(V)oxid; Caesiumoxid; Strontiumtitanat; Zinkstannat; ein komplexes Oxid vom Perowskit-Typ, insbesondere Bariumtitanat; ein binäres Eisenoxid; ein ternäres Eisenoxid.

11. Photovoltaisches Element (110) nach einem der vorhergehenden Ansprüche, wobei das n-halbleitende Metalloxid (120) mindestens ein n-halbleitendes Metalloxid (120) in nanopartikulärer oder amorpher Form aufweist.

12. Photovoltaisches Element (110) nach einem der vorhergehenden Ansprüche, wobei das n-halbleitende Metalloxid mindestens ein erstes Metalloxid aufweist, welches mit mindestens einem zweiten Metalloxid beschichtet ist.

13. Photovoltaisches Element (110) nach einem der vorhergehenden Ansprüche, wobei der Farbstoff (122) mindestens eines der folgenden Sensibilisatormaterialien aufweist: einen Übergangsmetallkomplex, insbesondere einen Rutheniumkomplex; eine Indolinverbindung; eine Cyaninverbindung; eine Merocyaninverbindung; eine Oxazinverbindung; eine Thiazinverbindung; eine Acridinverbindung; eine Porphyrinverbindung; ein Rylenderivat; eine Perylenverbindung; eine Terrylenverbindung; eine Quaterrylenverbindung.

14. Photovoltaisches Element (110) nach einem der vorhergehenden Ansprüche, wobei die Farbstoffsolarzelle (126) zwischen dem n-halbleitenden Metalloxid (120) und dem p-Halbleiter (124) ein Passivierungsmaterial aufweist, welches eingereichtet ist, um einen Elektronentransfer zwischen dem n-halbleitenden Metalloxid (120) und dem p-Halbleiter (124) zumindest teilweise zu verhindern.

15. Photovoltaisches Element (110) nach einem der vorhergehenden Ansprüche, wobei der p-Halbleiter (124) mindestens eines der folgenden Materialien aufweist: einen anorganische Festkörper, insbesondere Kupfer(I)iodid und/oder Kupfer(I)thiocyanat; ein leitfähiges organisches Material, insbesondere ein Polythiophen, ein Polyarylamin; einen organischen p-Halbleiter, insbesondere ein reversibel oxidierbares organisches Material, insbesondere eine nicht-polymere organische Verbindung, insbesondere ein Spirobifluoren.

16. Photovoltaisches Element (110) nach einem der vorhergehenden Ansprüche, wobei das Akzeptormaterial (132) mindestens eines der folgenden Materialien aufweist: ein Rhodamin; ein Triphenylmethan; ein Fulleren, insbesondere C60 oder C70; ein chemisch modifiziertes Fulleren; ein Nanoröhrchenmaterial; ein Nanostäbchenmaterial; ein Quantenpunktmaterial, insbesondere ein Quantenpunktmaterial, welches auf mindestens einem der folgenden Werkstoffe basiert:
CdSe, CdTe, CdS, HgTe, PbS, CulnS₂; ein anorganisches Halbleitermaterial, insbesondere ein in Form von Nanopartikeln oder Nanostäbchen vorliegendes anorganisches Halbleitermaterial, insbesondere eines der folgenden Materialien: Zinkoxid, Zinnoxid, TiO₂ ein n-halbleitendes Polymer, insbesondere ein auf Poly(p-Phenylen-Vinylen) basierendes Polymer, insbesondere CN-PPV oder MEH-PPV; einen Rylendümidfarbstoff, insbesondere einen auf einem der folgenden Verbindungen basierenden Farbstoff: Napthalen, Perylen, Terrylen, Quaterrylen, Pentarylen, Hexarylen, Heptarylen, Octarylen, insbesondere in pigmentierter Form oder in Form von Flüssigkrystallinderivaten; eine Rylenmonoimidverbindung, insbesondere einen auf einer der folgenden Verbindungen basierenden Farbstoff: Napthalen; Perylen; Terrylen; Quaterrylen; Pentarylen; Hexarylen; Heptarylen; Octarylen; ein Bisimidazolderivat, insbesondere PTCBI oder ein Pyrimidin-Derivat, wobei alle genannten Materialien vorzugsweise ganz oder teilweise in pigmentierter Form oder in Form von Flüssigkrystallinderivaten vorliegen.

17. Photovoltaisches Element (110) nach einem der vorhergehenden Ansprüche, wobei das Donatormaterial (134) mindestens eines der folgenden Materialien umfasst: ein Pentacen; ein Phthalocyanin; ein Subphthalocyanin; eine Phthalocyaninverbindung; eine Porphyrinverbindung; eine Merocyaninverbindung; ein Flüssigkristallmaterial, insbesondere ein diskotisches Flüssigkristallmaterial; ein Thiophen; eine Thiophen-haltige niedermolekulare Verbindung; ein Thiophen-haltiges Oligomer; ein Thiophengruppen enthaltendes Polymer; ein auf p-Phenylen-Vinylen basierendes Polymer; ein auf p-Phenylen-Vinylen basierendes Oligomer; ein Polyfluoren; ein alternierendes Polyfluoren-Copolymer; ein Polycarbazol; ein Carbazol enthaltendes Oligomer; ein Carbazol enthaltendes Polymer; ein auf Polyanilin basierendes Polymer; ein Anilin enthaltendes Oligomer; ein Anilin enthaltendes Polymer; eine Verbindung der Klasse der Triarylamine; eine Verbindung der Klasse der Polytriarylamine; eine Verbindung der Klasse der Polycyclopentadiene; eine Verbindung der Klasse der Polypyrrole; eine Verbindung der Klasse der Polyfurane; eine Verbindung der Klasse der Polysilole; eine Verbindung der Klasse der Polyphosphole; ein Benzidin-Derivat, insbesondere TPD, TAD oder NPD; ein Carbazol, insbesondere CBP; eine Spiro-Verbindung, insbesondere MeOTAD; ein Rylenderivat; ein Fulleren oder ein Fulleren-Derivat; Kupfer(I)iodid; Kupfer(I)thiocyanat.

18. Photovoltaisches Element (110) nach einem der vorhergehenden Ansprüche, wobei die organische Solarzelle (130) mindestens eine Blockierschicht (136) aufweist, wobei die Blockierschicht (136) zwischen der zweiten Elektrode (138) und mindestens einem weiteren Material der organischen Solarzelle (130) angeordnet ist und vorzugsweise mindestens eines der folgenden Lochleitenden Materialien aufweist: ein NPD; TPD; NPB; MTDATA; DPBIC; Spiro-MeOTAD; ein Benzidin-Derivat, insbesondere α-NPD.

19. Verfahren zur Herstellung eines photovoltaischen Elements (110), insbesondere eines photovoltaischen Elements (110) nach einem der vorhergehenden Ansprüche, wobei das Verfahren folgende Schritte aufweist:
- eine Farbstoffsolarzelle (126) wird hergestellt, wobei folgende Schritte durchgeführt werden:
o mindestens ein n-halbleitendes Metalloxid (120) wird auf eine erste Elektrode (118) aufgebracht;
o mindestens ein in einem ersten Spektralbereich elektromagnetische Strahlung absorbierender Farbstoff (122) wird auf das n-halbleitende Metalloxid (120) aufgebracht;
o mindestens ein fester p-Halbleiter (124) wird auf das n-halbleitende Metalloxid (120) aufgebracht;
- eine organische Solarzelle (130) wird hergestellt, wobei die organische Solarzelle ausgestaltet ist, um elektromagnetische Strahlung in einem zweiten Spektralbereich zu absorbieren, welcher von dem ersten Spektralbereich zumindest teilweise verschieden ist, wobei folgende Schritte durchgeführt werden:
o mindestens ein Akzeptormaterial (132) wird auf die Farbstoffsolarzelle (126) aufgebracht;
o mindestens ein Donatormaterial wird auf die Farbstoffsolarzelle (126) aufgebracht,
o auf einer der Farbstoffsolarzelle (126) gegenüberliegenden Seite wird mindestens eine zweite Elektrode (138) aufgebracht, wobei die erste Elektrode (118) und/oder die zweite Elektrode (138) für die elektromagnetische Strahlung zumindest teilweise transparent ist,
- wobei das photovoltaische Element (110) zwischen der Farbstoffsolarzelle (126) und dem organischen Akzeptormaterial (132) der organischen Solarzelle (130) mindestens eine Ladungsrekombinationszone (128) aufweist..

## Claims

1. A photovoltaic element (110) for converting electromagnetic radiation into electrical energy, the photovoltaic element (110) having a tandem cell structure, wherein the tandem cell structure comprises the following:
- a dye solar cell (126) having a first electrode (118), an n-type semiconducting metal oxide (120), a dye (122) absorbing electromagnetic radiation in a first spectral range and a solid p-type semiconductor (124); and
- an organic solar cell (130) having an acceptor material (132) and a donor material (134), the acceptor material (132) and/or the donor material (134) comprising an organic material, the organic solar cell (130) furthermore comprising a second electrode (138) on an opposite side from the dye solar cell (126), and the organic solar cell being configured to absorb electromagnetic radiation in a second spectral rage, which is at least partially different to the first spectral range,
- the first electrode (118) and/or the second electrode (138) being at least partially transparent for the electromagnetic radiation,
- the photovoltaic element (110) comprising at least one charge recombination zone (128) between the dye solar cell (126) and the organic acceptor material (132) of the organic solar cell (130).

2. The photovoltaic element (110) according to the preceding claim, therein the tandem cell structure is a two-contact tandem cell structure, the photovoltaic element (110) comprising a first electrical contact electrically connected to the first electrode (118), and a second electrical contact electrically connected to the second electrode (138).

3. The photovoltaic element (110) according to either of the preceding claims, wherein the charge recombination zone (128) comprises at least one of the following materials: a metal, in particular Ag, Au, Li, Al, Ti or Sn; a metal halide, in particular LiF; a metal oxide, in particular WO₃; a doped metal oxide; a region doped with defects, in particular a region in which a layer structure of the organic solar cell (130) is modified so that defects are introduced into the layer structure; a highly doped p/n junction.

4. The photovoltaic element (110) according to any of the preceding claims, wherein the charge recombination zone (128) has a layer thickness of less than 2.0 nm.

5. The photovoltaic element (110) according to any of the preceding claims, wherein at least one electron transport layer (129) is also introduced between the charge recombination zone (128) and the organic solar cell (130).

6. The photovoltaic element (110) according to any of the preceding claims, wherein the organic solar cell (130) comprises a transition between a layer of the acceptor material (132) and a layer of the donor material (134), the layer of acceptor material (132) being arranged on a side facing the dye solar cell (126) and the layer of donor Material (134) being arranged on a side of the transition facing away from the dye solar cell (126).

7. The photovoltaic element (110) according to any of the preceding claims, herein at least one buffer layer (119), in particular a buffer layer (119) comprising a buffer metal oxide, in particular a transparent buffer metal oxide, is introduced between the first electrode (118) and the n-type semiconducting metal oxide (120).

8. The photovoltaic element (110) according to any of the preceding claims, wherein the first electrode (118) and/or the second electrode (138) comprises at least one of the following materials: a metal foil, in particular an aluminum foil or a silver foil; a metal film, in particular an aluminium film or a silver film; a transparent conducting oxide, in particular tin oxide doped with fluorine and/or with indium or aluminum-doped zinc oxide; carbon nanotubes.

9. The photovoltaic element (110) according to any of the preceding claims, wherein one and only one of the first and second electrodes (118, 138) is at least partially transparent for the electromagnetic radiation, and wherein the other of the first and second electrodes (118, 138) is at least partially reflective for the electromagnetic radiation.

10. The photovoltaic element (110) according to any of the preceding claims, wherein the n-type semiconducting metal oxide (120) comprises at least one of the following materials: zinc oxide; tin dioxide; titanium dioxide; tin(IV) oxide; tungsten (VI) oxide; tantalum(V) oxide; niobium(V) oxide; cesium oxide; strontium titanate; zinc stannate; a complex oxide of the perovskite type, in particular barium titanate; a binary iron oxide; a ternary iron oxide.

11. The photovoltaic element (110) according to any of the preceding claims, wherein the n-type semiconducting metal oxide (120) comprises at least one n-type semiconducting metal oxide (120) in nanoparticulate or amorphous form.

12. The photovoltaic element (110) according to any of the preceding claims, wherein the n-type semiconducting metal oxide comprises at least one first metal oxide, which is coated with at least one second metal oxide.

13. The photovoltaic element (110) according to any of the preceding clams, wherein the dye (122) comprises at least one of the following sensitizer materials: a transition metal complex, in particular a ruthenium complex; an indoline compound; a cyanine compound; a merocyanine compound; an oxazine compound; a thiazine compound; an acridine compound; a porphyrin compound; a rylene derivative; a perylene compound; a terrylene compound; a quaterrylene compound.

14. The photovoltaic element (110) according to any of the preceding claims, wherein the dye solar cell (126) comprises a passivation material between the n-type semiconducting metal oxide (120) and the p-type semiconductor (124), which is adapted to at least partly prevent electron transfer between the n-type semiconducting metal oxide (120) and the p-type semiconductor (124).

15. The photovoltaic element (110) according to any of the preceding claims, wherein the p-type semiconductor (124) comprises at least one of the following materials: an inorganic solid, in particular copper(I) iodide and/or copper(I) thiocyanate; a conducing organic material, in particular a polythiophene, a polyaryl amine; an organic p-type semiconductor, in particular a reversibly oxidizable organic material, in particular a non-polymeric organic compound, in particular a spirobifluorene.

16. The photovoltaic element (110) according to any of the preceding claims, wherein the acceptor material (132) comprises at least one of the following materials: a rhodamine; a triphenyl methane; a fullerene, in particular C60 or C70; a chemically modified fullerene; a nanotube material; a nanorod material; a quantum dot material, in particular a quantum dot material which is based on at least one of the following substances: CdSe, CdTe, CdS, HgTe, PbS, CuInS₂; an inorganic semiconductor material, in particular an inorganic semiconductor material in the form of nanoparticles or nanorods, in particular one of the following materials: zinc oxide, tin oxide, TiO₂; an n-type semiconducting polymer, in particular a polymer based on poly (p-phenylene-vinylene), in particular CN-PPV or MEH-PPV; a rylene diimide dye, in particular a dye based on one of the following compounds: naphthalene, perylene, terrylene, quaterrylene, pentarylene, hexarylene, heptarylene, octarylene, particularly in pigmented form or in the form of liquid crystalline derivatives; a rylene monoimide compound, in particular a dye based on one of the following compounds: naphthalene, perylene, terrylene, quaterrylene, pentarylene, hexarylene,
heptarylene, octarylene; a bisimidazole derivative, in particular PTCBI or a pyrimidine derivative, all said materials preferably being entirely or partially present in pigmented form or in the form of liquid crystalline derivatives.

17. The photovoltaic element (110) according to any of the preceding claims, wherein the donor material (134) comprises at least one of the following materials: a pentacene; a Phthalocyanine; a subphthalocyanine; a phthalocyanine compound; a porphyrin compound; a merocyanine compound; a liquid crystal material, in particular a discotic liquid crystal material; a thiophene; a low molecular weight compound containing thiophene; an oligomer containing thiophene; a polymer containing thiophene groups; a polymer based on p-phenylene-vinylene; an oligomer based on p-phenylene-vinylene; a polyfluorene; an alternating polyfluorene copolymer; a polycarbazole; an oligomer containing carbazole, a polymer containing carbazole; a polymer based on polyaniline; an oligomer containing aniline; a polymer containing aniline; a compound of the triarylamine class; a compound of the polytriarylamine class; a compound of the polycyclopentadiene class; a compound of the polypyrrole class; a compound of the polyfuran class; a compound of the polysilole class; a compound of the polyphosphole class; a benzidine derivative, in particular TPD, TAD or NPD; a carbazole, in particular CBP; a spiro compound, in particular MeOTAD; a rylene derivative; a fullerene or a fullerene derivative; copper(I) iodide; copper(I) thiocyanate.

18. The photovoltaic element (110) according to any of the preceding clams, wherein the organic solar cell (130) comprises at least one blocking layer (136), the blocking layer (136) being arranged between the second electrode (138) and at least one further material of the organic solar cell (130) and preferably comprising at least one of the following hole-conducting materials: an NPD; TPD; NPB; MTDATA; DPBIC; spiro-MeOTAD; a benzidine derivative, in particular α-NPD.

19. A method for producing a photovoltaic element (110), in particular a photovoltaic element (110) according to any of the preceding claims, wherein the method comprises the following steps:
- a dye solar cell (126) is produced, the following steps being carried out:
o at least one n-type semiconducting metal oxide (120) is applied onto a first electrode (118);
o at least one dye (122) absorbing electromagnetic radiation in a first spectral range is applied onto the n-type semiconducting metal oxide (120);
o at least one solid p-type semiconductor (124) is applied onto the n-type semiconducting metal oxide (120);
- an organic solar cell (130) is produced, the organic solar cell being configured to absorb electromagnetic radiation in a second spectral range, which is at least partially different to the first spectral range, the following steps being carried out:
o at least one acceptor material (132) is applied onto the dye solar cell (126);
o at least one donor material is applied onto the dye solar cell (126);
o at least one second electrode (138) is applied onto the opposite side from the dye solar cell (126), the first electrode (118) and/or the second electrode (138) being at
least partially transparent for the electromagnetic radiation,
- the photovoltaic element (110) comprising at least one charge recombination zone (128) between the dye solar cell (126) and the organic acceptor material (132) of the organic solar cell (130).

## Revendications

1. Elément photovoltaïque (110) destiné à convertir un rayonnement électromagnétique en énergie électrique, l'élément photovoltaïque (110) présentant une structure de cellule en tandem, la structure de cellule en tandem comportant :
- une cellule solaire (126) à colorant qui présente une première électrode (118), un oxyde métallique (120) semi-conducteur n, un colorant (122) qui absorbe le rayonnement électromagnétique dans une première plage spectrale et un semi-conducteur p solide (124), et
- une cellule solaire organique (130) qui présente un matériau accepteur (132) et un matériau donneur (134) le matériau accepteur (132) et/ou le matériau donneur (134) comportant un matériau organique, la cellule solaire organique (130) comportant en outre une deuxième électrode (138) sur un côté situe face à la cellule solaire (126) à colorant, la cellule solaire organique étant configurée pour absorber le rayonnement électromagnétique dans une deuxième plage spectrale qui est au moins en partie différente de la première plage spectrale,
- la première électrode (118) et/ou la deuxième électrode (138) étant au moins en partie transparentes vis-à-vis du rayonnement électromagnétique et
- l'élément photovoltaïque (110) présentait au moins une zone (128) de recombinaison de charges entre la cellule solaire (126) à colorant et le matériau organique accepteur (132) de la cellule organique solaire (130).

2. Elément photovoltaïque (110) selon la revendication précédente, dans lequel la structure de cellule en tandem est une structure de cellule en tandem à deux contactes, l'élément photovoltaïque (110) présentant un premier contact électrique relié électriquement à la première électrode (118) et un deuxième contact électrique relié électriquement à la deuxième électrode (138).

3. Elément photovoltaïque (110) selon l'une des revendications précédentes, dans lequel la zone (128) de recombinaison de charges présente au moins l'un des matériaux suivants : un métal, en particulier Ag, Au, Li, Al, Ti ou Sn, un halogénure de métal, en particulier LiF, un oxyde métallique, en particulier WO₃, un oxyde métallique dopé, une zone dopée en défauts, en particulier une zone dans laquelle une structure stratifiée de la cellule solaire organique (130) est modifiée de manière à apporter des défauts dans la structure stratifiée, et une transition p/n fortement dopée.

4. Elément photovoltaïque (110) selon l'une des revendications précédentes, dans lequel la zone (128) de combinaison de charges est une couche d'une épaisseur inférieure à 2,0 nm.

5. Elément photovoltaïque (110) selon l'une des revendications précédentes, dans lequel au moins une couche (129) de transport d'électrons est placée en outre entre la zone (128) de recombinaison de charges et la cellule solaire organique (130).

6. Elément photovoltaïque (110) selon l'une des revendications précédentes, dans lequel la cellule solaire organique (130) présente une transition entre une couche de matériau accepteur (132) et une couche de matériau donner (134), la couche de matériau accepteur (132) étant disposée sur un côté non tourné vers à cellule solaire (126) à colorant et la couche de matériau donneur (134) sur un côté de la transition non tourné vers la cellule solaire (126) à colorant.

7. Elément photovoltaïque (110) selon l'une des revendications précédentes, dans lequel au moins une couche tampon (119), en particulier une couche tampon (119) dotée d'un oxyde métallique tampon et en particulier d'un oxyde métallique tampon, transparent, est prévue entre la première électrode (118) et l'oxyde métallique (120) semi-conducteur n.

8. Elément photovoltaïque (110) selon l'une des revendications précédentes, dans lequel la première électrode (118) et/ou la deuxième électrode (138) présentent au moins l'un des matériaux suivants : une feuille métallique, en particulier une feuille d'aluminium ou une feuillue d'argent, un film métallique, en particulier un fils d'aluminium ou un film d'argent, un oxyde conducteur transparent, en particulier un oxyde d'étain dopé au Fluor et/ou à l'indium ou un oxyde de zinc dopé à l'aluminium, et des nanotubes de carbone.

9. Element photovoltaïque (110) selon l'une des revendications précédentes, dans lequel l'une parmi la première et la deuxième électrode (118, 138) est au moins partiellement transparente vis-à-vis du rayonnement électromagnétique, l'autre parmi la première et la deuxième électrode (118, 138) étant au moins partiellement réfléchissante pour le rayonnement électromagnétique.

10. Elément photovoltaïque (110) selon l'une des revendications précédentes, dans lequel l'oxyde métallique (120) semi-conducteur n présenté au moins l'un des matériaux suivants : oxyde de zinc, dioxyde d'étain, bioxyde de titane, oxyde d'étain (IV), oxyde de tungstène (VI), oxyde de tantale (V), oxyde de niobium (V), oxyde dé césium, titanate de strontium, stannate de zinc, oxyde complexé de type perovskite, en particulier titanate de baryum, un oxyde de fer binaire ou un oxyde de fer tertiaire.

11. Elément photovoltaïque (110) selon l'une des revendications précédentes, dans lequel l'oxyde métallique (120) semi-conducteur n présente au moins un oxyde métallique (120) semi-conducteur n sous forme de nanoparticules ou sous forme amorphe.

12. Elément photovoltaïque (110) selon l'une des revendication précédentes, dans lequel l'oxyde métallique semi-conducteur n présente au moins un premier oxyde métallique revêtu d'au moins un deuxième oxyde métallique.

13. Elément photovoltaïque (110) selon l'une des revendications précédentes, dans lequel le colorant (122) présente au moins l'un des matériaux de sensibilisation suivants : une complexe de métal de transition, en particulier un complexe de ruthénium, un composé d'indoline, un composé de cyanine, un composé de mérocyanine, un composé d'oxazine, un composé de thiamine, un composé d'acridine, un composé de Porphyrine, un dérivé de xylène, un composé de pérylène, un composé de terrylène ou un composé de quaterrylène.

14. Elément photovoltaïque (110) selon l'une des revendications précédentes, dans lequel la cellule solaire (126) à colorant présente entre l'oxyde métallique (120) semi-conducteur n et le semi-conducteur p (124) un matériau de passivation destiné à empêcher au moins partiellement un transfert d'électrons entre l'oxyde métallique (120) semi-conducteur n et le semi-conducteur p (124).

15. Elément photovoltaïque (110) selon l'une des revendications précédente dans lequel le semi-conducteur p (124) présente au moins l'un des matériaux suivantes : un corps solide minéral, en particulier de l'iodure de cuivre (I) et/ou du thiocyanate de cuivre (I), un matériau organique conducteur, en particulier un polythiopène ou une polyarylamine, un semi-conducteur organique p, en particulier un matériau organique oxydable de manière réversible, en particulier un composé organique non polymère et notamment un spirobifluorène,

16. Elément photovoltaïque (110) selon l'une des revendications précédentes, dans lequel un matériau accepteur (132) présente au moins l'un des matériaux suivants : la rhodamine, le triphénylméthane, un fullerène, en particulier en C60 ou C70, un fullerène modifié chimiquement, un matériau en nanotubes, un matériau en nanobarres, une matériau à point quantique, en particulier un matériau à point quantique basé sur l'un des matériaux suivants : CdSe, CdTe, CdS, HgTe, PbS, CuInS₂, un matériau semi-conducteur minéral, en particulier un matériau semi-conducteur minéral présent sous forme de nanoparticules ou de nanobarres, et en particulier un des matériaux suivantes : oxyde de zinc, oxyde d'étain, TiO₂, un polymère semi-conducteur n, en particulier un polymère à base de poly(p-phénylène-vinylène), en particulier le CN-PPV ou le MEH-PPV, un colorant à diimide de rylène, en particulier un colorant basé sur l'un des composés suivants :
naphtalène, pérylène, terrylène, quaterrylène, pentarylène, hexarylène, heptarylène, octarylène, en particulier sous forme pigmentée ou sous forme de dérivé en cristaux liquides, un composé de monoimide de rylène, en particulier un colorant basé sur l'un des composés suivantes : naphtalènes, pérylène, terrylène, quaterrylène, pentarylène, hexarylène, heptarylène, octarylène, un dérivé de bisimidazole, en particulier de PTCBI ou un dérivé de pyrimidine, tous les matériaux cités présentant de préférence en tout ou en partie la forme pigmentée ou la forme de dérivés en cristaux liquides.

17. Elément photovoltaïque (110) selon l'une des revendications précédentes, dans lequel le matériau donneur (134) comporte au moins l'un des matériaux suivants : un pentacène, une phtalocyanine, une sub-phtalocyanine, un composé de phtalocyanine, un composé de porphyrine, un composé de mérocyanine, un matériau en cristaux liquides, en particulier un matériau en cristaux liquides discotiques, un thiophène, un composé à bas poids moléculaire contenant du thiophène, un oligomère contenant du thiophène, un polymère contenant des groupes thiophène, un polymère à base de p-phéhylène-vinylène, un oligomère à base de p-phénylène-vinylène, un polyfluorène, un copolymère alterné de fluorène, un polycarbazole, un oligomère contenant du carbazole, un polymère contenant du carbazole, un polymère à base de polyaniline, un oligomère contenant de l'aniline, un polymère contentant de l'aniline, un composé de la classe des triarylamines, un composé de la classe des polytriarylamines, un composé de la classe des polycyclopentadiènes, un composé de la classe des polypyroles, un composé de la classe des polyfuranes, un composé de la classe des polysilols, un composé de la classe des polyphosphols, un dérivé de benzidine, en particulier un TPD, TAD ou NPD, un carbazole, en particulier un CBP, un composé spiro, en particulier un MeOTAD, un dérivé de rylène, un fullerène ou un dérivé de fullerène, l'iodure de cuivre (I) ou le thiocyanate de cuivre (I).

18. Elément photovoltaïque (110) selon l'une des revendications précédentes, dans lequel la cellule solaire organique (130) présente au moins une couche de blocage (136), la couche de blocage (136) étant disposée entre la deuxième électrode (138) et au moins un autre matériau de la cellule organique (130) et présentant de préférence au moins l'un des matériaux conducteurs de trous suivants: un NPD, un TPD, un NPB, un MTDATA, un DPBIC, un spiro-MeOTAD, un dérivé de benzidine et en particulier un α-NPD.

19. Procédé de fabrication d'un élément photovoltaïque (110), en particulier d'un élément photovoltaïque (110) selon l'une des revendications précédentes, le procédé comportant les étapes suivante :
- on prépare une cellule solaire (126) à colorant en exécutant les étapes suivantes :
- on place au moins un oxyde métallique (120) semi-conducteur n sur une première électrode (118),
- on applique au moins un colorant (122) qui absorbe le rayonnement électromagnétique dans une première plage spectrale sur l'oxyde métallique (120) semi-conducteur n,
- on applique au moins un semi-conducteur p solide (124) sur l'oxyde métallique (120) semi-conducteur n,
- on prépare une cellule solaire organique (130), la cellule solaire organique étant configurée pour absorber le rayonnement électromagnétique dans une deuxième plage spectrale qui est au moins partiellement différente de la première plage spectrale, en exécutant les étapes suivantes :
- on applique au moins un matériau accepteur (132) sur la cellule solaire (126) à colorant,
- on applique au moins un matériau donneur sur la cellule solaire (126) à colorant,
- on applique au moins une deuxième électrode (138) sur un côté opposé à la cellule solaire (126) à colorant, la première électrode (118) et/ou la deuxième électrode (138) étant au moins partiellement transparentes vis-à-vis du rayonnement électromagnétique,
- l'élément photovoltaïque (110) présentant au moins une zone (128) de recombinaison de charges entre la cellule solaire (126) à colorant et le matériau organique accepteur (132) de la cellule solaire organique (130).
